# EUROPEAN PATENT APPLICATION

(11) **EP 4 583 311 A1**
(43) Date of publication of application: **09.07.2025**
(21) Application number: 23875177.0
(22) Date of filing: 27.09.2023
(51) Int. Cl.: H01Q 9/04, H01Q 1/24, H01Q 1/02, H04M 1/02, H05K 1/02

(54) **ANTENNA STRUCTURE AND ELECTRONIC DEVICE COMPRISING SAME**

(30) Priority: 06.10.2022 KR 20220127563; 03.11.2022 KR 20220145448
(71) Applicant: Samsung Electronics Co., Ltd., Suwon-si, Gyeonggi-do 16677 (KR)
(72) Inventor: HWANG, Soonho, Suwon-si, Gyeonggi-do 16677 (KR); LEE, Kookjoo, Suwon-si, Gyeonggi-do 16677 (KR); CHOI, Donguk, Suwon-si, Gyeonggi-do 16677 (KR); PARK, Sungkoo, Suwon-si, Gyeonggi-do 16677 (KR); YUN, Himchan, Suwon-si, Gyeonggi-do 16677 (KR); LEE, Kyungjae, Suwon-si, Gyeonggi-do 16677 (KR); KIM, Seunghwan, Suwon-si, Gyeonggi-do 16677 (KR); LEE, Hyunjeong, Suwon-si, Gyeonggi-do 16677 (KR); CHUN, Jaebong, Suwon-si, Gyeonggi-do 16677 (KR)
(74) Representative: HGF
(86) International application number: PCT/KR2023/015126
(87) International publication number: WO 2024/076113

(57) **Abstract**

An electronic device according to an embodiment of the present invention may comprise: a housing including a first surface, a second surface, and a lateral surface surrounding a space between the first surface and the second surface; a printed circuit board disposed inside the housing and including a wireless communication module; and an antenna structure electrically connected to the printed circuit board and disposed in one direction of the printed circuit board. The antenna structure may include: a dielectric material; a first patch antenna, a second patch antenna, and a third patch antenna disposed on a first surface of the dielectric material or adjacent to the first surface and electrically connected to the wireless communication module; a ground layer disposed on a second surface of the dielectric material or between the second surface and the first patch antenna, the second patch antenna, and the third patch antenna; and a first heat dissipation member surrounding at least a part of the first patch antenna, the second patch antenna, and the third patch antenna and arranged to be couplable to at least one of the first patch antenna, the second patch antenna, and the third patch antenna.

## Description

### [Technical Field]

Various embodiments of the disclosure relate to an antenna structure including at least one patch antenna and an electronic device including the antenna structure.

### [Background Art]

The uses of electronic devices, such as a bar type, a foldable type, a rollable type, or a sliding type, are increasing, and various functions are being provided to an electronic device.

The electronic device may include a printed circuit board (PCB) on which various electronic components are arranged.

The electronic device may make a phone call with other electronic devices and may transmit and receive various data by using a wireless communication module disposed on the printed circuit board.

The electronic device may include at least one antenna module in order to perform wireless communication with other electronic devices by using a network.

### [Disclosure of Invention]

### [Technical Problem]

An antenna module (e.g., an antenna structure) of an electronic device may include at least one patch antenna.

The electronic device may perform ultra-wideband (UWB) communication through at least one patch antenna included in the antenna module, and may support the angle of arrival (AoA) service which enables the positions of other electronic devices to be measured.

At least one patch antenna disposed on the antenna module of the electronic device may have a narrow or a limited bandwidth due to the structure in which the patch antenna is disposed on a dielectric on a ground layer.

The electronic device may include multiple electronic components (e.g., a processor, a memory, a camera, and/or a flash LED) having an improved degree of integration, which are arranged on a printed circuit board. In case that heat generated from multiple electronic components densely integrated on a printed circuit board is not dissipated, the performance of the electronic device may be deteriorated or the electronic device may not operate properly.

Various embodiments of the disclosure may provide an antenna structure (e.g., an antenna module) which can improve the bandwidth of a patch antenna by using a first heat dissipation member which surrounds at least a part of the patch antenna and is used as an antenna radiation body through coupling with the patch antenna, and an electronic device including the antenna structure.

Various embodiments of the disclosure may provide an electronic device having an increased heat dissipation area by using a second heat dissipation member connected to a first heat dissipation member surrounding at least a part of a patch antenna through at least one connection part.

The technical solutions to be achieved in the disclosure are not limited to the technical solution mentioned above, and other technical solutions not mentioned will be obviously understood by a person skill in the technical field to which the disclosure belongs from the description below.

### [Solution to Problem]

An electronic device according to an embodiment of the disclosure may include a housing including a first surface, a second surface, and a side surface surrounding a space between the first surface and the second surface, a printed circuit board which is disposed inside the housing and includes a wireless communication module, and an antenna structure electrically connected to the printed circuit board and disposed in one direction of the printed circuit board. According to an embodiment, the antenna structure may include a dielectric, a first patch antenna, a second patch antenna, and a third patch antenna arranged on a first surface of the dielectric or adjacent to the first surface and electrically connected to the wireless communication module, a ground layer disposed on a second surface of the dielectric or between the second surface and the first patch antenna, the second patch antenna, and the third patch antenna, and a first heat dissipation member which surrounds at least parts of the first patch antenna, the second patch antenna, and the third patch antenna, and is disposed to be couplable to at least one of the first patch antenna, the second patch antenna, and the third patch antenna.

### [Advantageous Effects of Invention]

According to various embodiments of the disclosure, a first heat dissipation member, which surrounds at least a part of a patch antenna and resonates through coupling with the patch antenna, may be used as an antenna radiation body, so that the radiation performance of the patch antenna is improved.

According to various embodiments of the disclosure, a second heat dissipation member connected to a first heat dissipation member surrounding at least a part of a patch antenna through at least one connection part is used to increase a heat dissipation area, so that the heat dissipation efficiency of an electronic device is improved.

In addition, various effects that can be directly or indirectly identified through the disclosure can be provided.

### [Brief Description of Drawings]

In the descriptions of drawings, the same or similar reference numerals may be used for the same or similar elements.
FIG. 1 is a block diagram of an electronic device in a network environment according to various embodiments of the disclosure.
FIG. 2A is a front perspective view of an electronic device according to various embodiments of the disclosure.
FIG. 2B is a rear perspective view of an electronic device according to various embodiments of the disclosure.
FIG. 3 is an exploded perspective view of an electronic device according to various embodiments of the disclosure.
FIG. 4 is a view schematically showing a configuration of an electronic device including an antenna structure and a first heat dissipation member according to an embodiment of the disclosure.
FIG. 5A is a view showing the radiation efficiency of a first patch antenna having at least a part surrounded by a first heat dissipation member of an electronic device according to an embodiment of the disclosure, and the radiation efficiency of a patch antenna according to a comparative embodiment.
FIG. 5B is a view showing the radiation efficiency of a second patch antenna having at least a part surrounded by a first heat dissipation member of an electronic device according to an embodiment of the disclosure, and the radiation efficiency of a patch antenna according to a comparative embodiment.
FIG. 5C is a view showing the radiation efficiency of a third patch antenna having at least a part surrounded by a first heat dissipation member of an electronic device according to an embodiment of the disclosure, and the radiation efficiency of a patch antenna according to a comparative embodiment.
FIG. 6A is a view showing an electric field distribution of a first heat dissipation member when a first patch antenna operates, in an electronic device according to an embodiment of the disclosure.
FIG. 6B is a view showing an electric field distribution of a first heat dissipation member when a second patch antenna operates, in an electronic device according to an embodiment of the disclosure.
FIG. 6C is a view showing an electric field distribution of a first heat dissipation member when a third patch antenna operates, in an electronic device according to an embodiment of the disclosure.
FIG. 7 is a view schematically showing a configuration of an electronic device including an antenna structure, a first heat dissipation member, and a second heat dissipation member according to an embodiment of the disclosure.
FIG. 8A is a view showing the radiation efficiency of a first patch antenna in case that a first heat dissipation member and a second heat dissipation member are connected through at least one connection part, in an electronic device according to an embodiment of the disclosure, the radiation efficiency of the first patch antenna according to a first comparative embodiment, and the radiation efficiency of the first patch antenna according to a second comparative embodiment.
FIG. 8B is a view showing the radiation efficiency of a second patch antenna in case that a first heat dissipation member and a second heat dissipation member are connected through at least one connection part, in an electronic device according to an embodiment of the disclosure, the radiation efficiency of the second patch antenna according to a first comparative embodiment, and the radiation efficiency of the second patch antenna according to a second comparative embodiment.
FIG. 8C is a view showing the radiation efficiency of a third patch antenna in case that a first heat dissipation member and a second heat dissipation member are connected through at least one connection part, in an electronic device according to an embodiment of the disclosure, the radiation efficiency of the third patch antenna according to a first comparative embodiment, and the radiation efficiency of the third patch antenna according to a second comparative embodiment.
FIG. 9A is a view showing a configuration in which a second patch antenna and a third patch antenna included in an antenna structure are surrounded by a first heat dissipation member, in an electronic device according to an embodiment of the disclosure.
FIG. 9B is a view showing a boundary shape between a first heat dissipation member, and a first patch antenna, a second patch antenna, and a third patch antenna of an electronic device according to an embodiment of the disclosure.
FIG. 9C is a view showing a configuration of a first heat dissipation member and a second heat dissipation member arranged in an antenna structure of an electronic device according to an embodiment of the disclosure.
FIG. 10A is a view schematically showing a configuration of an antenna structure including a patch antenna and a heat dissipation member, in an electronic device according to an embodiment of the disclosure.
FIG. 10B is a view showing the higher-order resonant frequency in which an antenna structure uses a patch antenna and a heat dissipation member, in an electronic device according to an embodiment of the disclosure, and the resonant frequency of the patch antenna according to a comparative embodiment.
FIG. 10C is a view showing the radiation efficiency of a patch antenna surrounded by a heat dissipation member of an electronic device according to an embodiment of the disclosure, and the radiation efficiency of the patch antenna according to a comparative embodiment.
FIG. 11 is a view schematically showing a configuration of various embodiments in which an antenna structure includes a patch antenna and a heat dissipation member, in an electronic device according to an embodiment of the disclosure.
FIG. 12A is a view showing the resonant frequency of a patch antenna surrounded by a heat dissipation member of an electronic device according to an embodiment of the disclosure, and the resonant frequency of the patch antenna according to a comparative embodiment.
FIG. 12B is a view showing the radiation efficiency of a patch antenna surrounded by a heat dissipation member of an electronic device according to an embodiment of the disclosure, and the radiation efficiency of the patch antenna according to a comparative embodiment.
FIG. 13 is a view showing an electric field distribution of a heat dissipation member when a patch antenna operates, in an electronic device according to an embodiment of the disclosure.
FIG. 14 is a view schematically showing a configuration of an electronic device including a patch antenna structure, a first heat dissipation member, and a second heat dissipation member according to an embodiment of the disclosure.
FIG. 15A is a view schematically showing a configuration in which a first heat dissipation member and a second heat dissipation member included in an electronic device are connected through three connection parts according to an embodiment of the disclosure.
FIG. 15B is a view schematically showing a configuration in which a first heat dissipation member and a second heat dissipation member included in an electronic device are connected through five connection parts according to an embodiment of the disclosure.
FIG. 15C is a view schematically showing a configuration in which a first heat dissipation member and a second heat dissipation member included in an electronic device are connected through six connection parts according to an embodiment of the disclosure.
FIG. 16A to FIG. 16E are views schematically showing configurations according to various embodiments of the arrangement structure of a first patch antenna, a second patch antenna, a first heat dissipation member, and a second heat dissipation member included in an electronic device according to an embodiment of the disclosure.
FIG. 16F to FIG. 16H are views schematically showing configurations according to various embodiments of the arrangement structure of a first patch antenna, a second patch antenna, a first heat dissipation member, a second heat dissipation member, and at least one connection part included in an electronic device according to an embodiment of the disclosure.
FIG. 17A to FIG. 17D are views schematically showing various widths of a connection part configured to connect a first heat dissipation member and a second heat dissipation member, in an electronic device according to an embodiment of the disclosure.
FIG. 18 is a view showing the radiation efficiency of a patch antenna according to the width of a connection part, in an electronic device according to an embodiment of the disclosure.

### [Mode for the Invention]

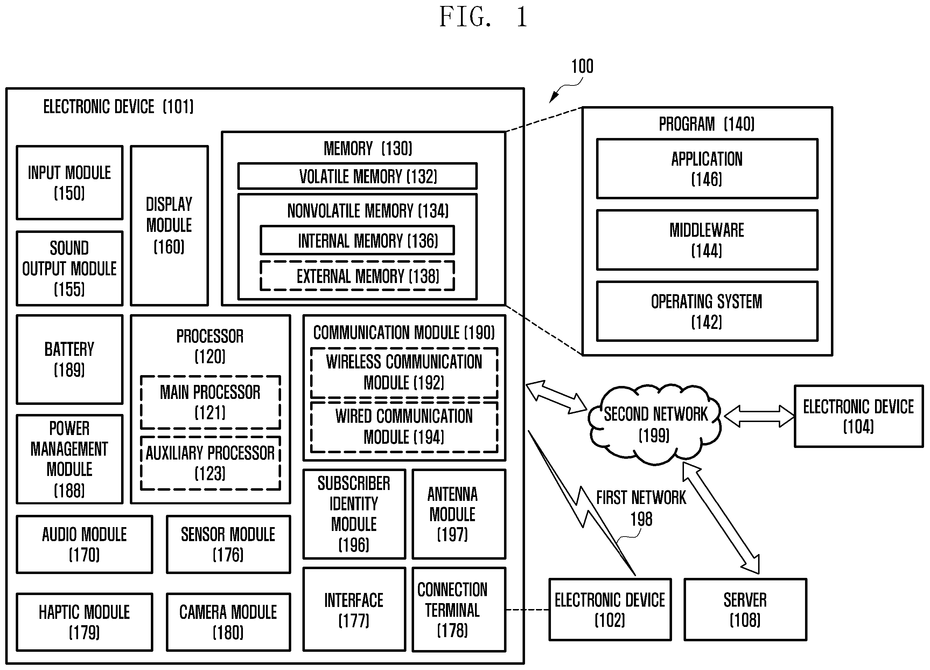

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

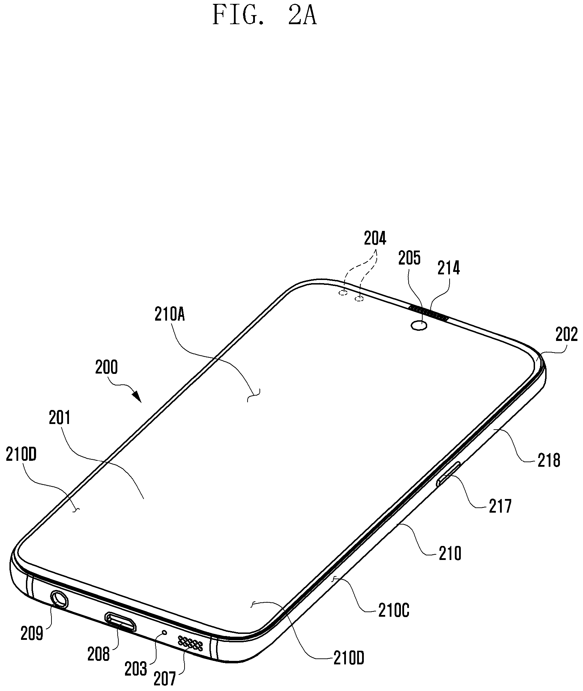

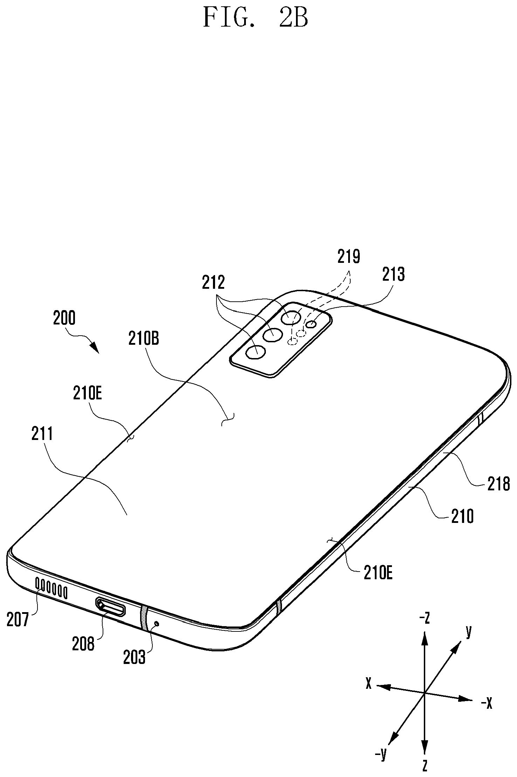

FIG. 2A is a front perspective view of an electronic device according to various embodiments of the disclosure. FIG. 2B is a rear perspective view of the electronic device in FIG. 2A according to various embodiments of the disclosure

Referring to FIG. 2A and FIG. 2B, an electronic device 200 according to an embodiment may include a housing 210 including a first surface (or front surface) 210A, a second surface (or rear surface) 210B, and a side surface 210C surrounding the space between the first surface 210A and the second surface 210B. In another embodiment (not illustrated), the housing may denote a structure that forms a part of the first surface 210A, the second surface 210B, and the side surface 210C illustrated in FIG. 2A and FIG. 2B. According to an embodiment, the first surface 210A may be formed by a front plate 202, at least a part of which is substantially transparent (for example, a glass plate including various coating layers, or a polymer plate). The second surface 210B may be formed by a rear plate 211 that is substantially opaque. The rear plate 211 may be made of coated or colored glass, ceramic, polymer, metal (for example, aluminum, stainless steel (STS), or magnesium), or a combination of at least two of the above-mentioned materials. The side surface 210C may be formed by a side bezel structure (or "side member") 218 which is coupled to the front plate 202 and to the rear plate 211, and which includes metal and/or polymer. In some embodiments, the rear plate 211 and the side bezel structure 218 may be formed integrally and may include the same material (for example, a metal material such as aluminum).

In the illustrated embodiment, the front plate 202 may include two first areas 210D on both ends of the long edge of the front plate 202 such that the two first areas 210D bend from the first surface 210A toward the rear plate 211 and extend seamlessly. In the illustrated embodiment (see FIG. 2B), the rear plate 211 may include two second areas 210E on both ends of the long edge such that the two second areas 210E bend from the second surface 210B toward the front plate 202 and extend seamlessly. In some embodiments, the front plate 202 (or the rear plate 211) may include only one of the first areas 210D (or the second areas 210E). In another embodiment, a part of the first areas 210D or the second areas 210E may not be included. In the above embodiments, when seen from the side surface of the electronic device 200, the side bezel structure 218 may have a first thickness (or width) on a part of the side surface, which does not include the first areas 210D or the second areas 210E as described above, and may have a second thickness that is smaller than the first thickness on a part of the side surface, which includes the first areas 210D or the second areas 210E.

According to an embodiment, the electronic device 200 may include at least one of a display 201, input module 203, sound output modules 207 and 214, sensor modules 204 and 219, camera modules 205, 212, and 213, a key input device 217, an indicator, and connector 208. In some embodiments, at least one of the constituent elements (for example, the key input device 217 or the indicator) of the electronic device 200 may be omitted, or the electronic device 200 may additionally include another constituent element.

The display 201 may be exposed through a corresponding part of the front plate 202, for example. In some embodiments, at least a part of the display 201 may be exposed through the front plate 202 that forms the first areas 210D of the side surface 210C and the first surface 210A. In some embodiments, the display 201 may have a corner formed in substantially the same shape as that of the adjacent outer periphery of the front plate 202. In another embodiment (not illustrated), in order to increase the area of exposure of the display 201, the interval between the outer periphery of the display 201 and the outer periphery of the front plate 202 may be formed to be substantially identical.

The input module 203 may include a microphone hole. The input module may include a plurality of microphones arranged therein such that the direction of a sound can be sensed in some embodiments. The sound output modules 207 and 214 may include an outer speaker hole 207 and a speech receiver hole 214. In some embodiments, the speaker holes 207 and 214 and the microphone hole 203 may be implemented as a single hole, or a speaker may be included (for example, a piezoelectric speaker) without the speaker holes 207 and 214.

The sensor modules 204 and 219 may generate an electric signal or a data value corresponding to the internal operating condition of the electronic device 200 or the external environment condition thereof. The sensor modules 204 and 219 may include, for example, a first sensor module 204 (for example, a proximity sensor) arranged on the first surface 210A of the housing 210, and/or a second sensor module (not illustrated) (for example, a fingerprint sensor), and/or a third sensor module 219 (for example, an HRM sensor) arranged on the second surface 210B of the housing 210, and/or a fourth sensor module (for example, a fingerprint sensor). The fingerprint sensor may be arranged not only on the first surface 210A (for example, the display 201) of the housing 210, but also on the second surface 210B thereof. The electronic device 200 may further include a sensor module not illustrated, for example, at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or a luminance sensor 204.

The camera modules 205, 212, and 213 may include a first camera device 205 arranged on the first surface 210A of the electronic device 200, a second camera device 212 arranged on the second surface 210B thereof, and/or a flash 213. The camera devices 205 and 212 may include a single lens or a plurality of lenses, an image sensor, and/or an image signal processor. The flash 213 may include, for example, a light-emitting diode or a xenon lamp. In some embodiments, two or more lenses (an infrared camera, a wide-angle lens, and a telephoto lens) and image sensors may be arranged on a single surface of the electronic device 200.

The key input device 217 may be arranged on the side surface 210C of the housing 210. **In** another embodiment, the electronic device 200 may not include a part of the above-mentioned key input device 217 or the entire key input device 217, and the key input device 217 (not included) may be implemented in another type, such as a soft key, on the display 201. In some embodiments, the key input device may include a sensor module 216 arranged on the second surface 210B of the housing 210.

The indicator may be arranged on the first surface 210A of the housing 210, for example. The indicator may provide information regarding the condition of the electronic device 200 in a light type, for example. In another embodiment, the indicator may provide a light source that interworks with operation of the camera module 205, for example. The indicator may include, for example, an LED, an IR LED, and a xenon lamp.

The connector hole 208 may include a first connector hole 208 capable of containing a connector (for example, a USB connector) for transmitting/receiving power and/or data to/from an external electronic device, and/or a second connector hole (for example, an earphone jack) capable of containing a connector for transmitting/receiving an audio signal to/from the external electronic device.

The camera module 205, sensor module 205 or indicator may be arranged to be exposed through the display 201. For example, the camera module 205, the sensor module 204, or the indicator may be arranged to be in contact with the external environment through a through hole. In another embodiment, some of the sensor module may be arranged to perform their functions without being visually exposed through the front plate 202 in the internal space of the electronic device. For example, in this case, an area of the display 201 facing the sensor module may not require a through hole.

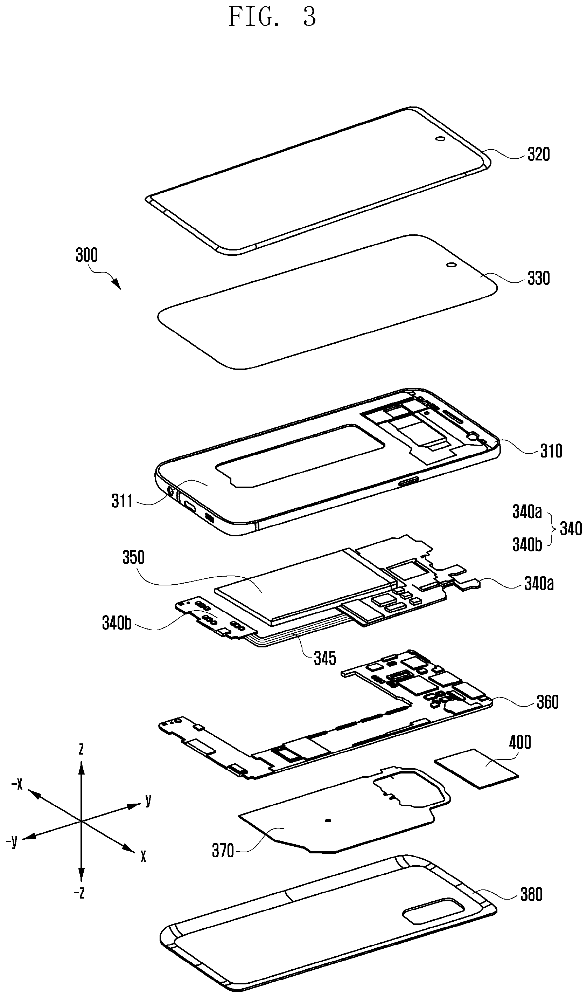

FIG. 3 is an exploded perspective view of the electronic device according to various embodiments of the disclosure.

Referring to FIG. 3, the electronic device 300 may include a side bezel structure 310, a first support member 311 (for example, a bracket), a front plate 320, a display 330, a printed circuit board 340, a battery 350, a second support member 360 (for example, a rear case), an antenna 370, and a rear plate 380. In some embodiments, at least one of the constituent elements (for example, the first support member 311 or the second support member 360) of the electronic device 300 may be omitted, or the electronic device 300 may further include another constituent element. At least one of the constituent elements of the electronic device 300 may be identical or similar to at least one of the constituent elements of the electronic device 101 or 200 of FIG. 1 to FIG. 2B, and repeated descriptions thereof will be omitted herein.

The first support member 311 may be arranged inside the electronic device 300 and connected to the side bezel structure 310, or may be formed integrally with the side bezel structure 310. The first support member 311 may be made of a metal material and/or a nonmetal (for example, polymer) material, for example. The display 330 may be coupled to one surface of the first support member 311, and the printed circuit board 340 may be coupled to the other surface thereof. A processor, a memory, and/or an interface may be mounted on the printed circuit board 340. The processor may include, for example, one or more of a central processing device, an application processor, a graphic processing device, an image signal processor, a sensor hub processor, or a communication processor.

For example, the printed circuit board 340 may include the processor 120, memory 130 and/or interface 177 disposed in the FIG. 1. For example, the processor may include one or more of a central processing unit, an application processor, a graphic processing unit, an image signal processor, a sensor hub processor, or a communication processor.

The memory may include a volatile memory or a non-volatile memory, for example.

The interface may include, for example, a high definition multimedia interface (HDMI), a universal serial bus (USB) interface, an SD card interface, and/or an audio interface. The interface may connect the electronic device 300 with an external electronic device electrically or physically, for example, and may include a USB connector, an SD card/MMC connector, or an audio connector.

The battery 350 is a device for supplying power to at least one constituent element of the electronic device 300, and may include a non-rechargeable primary cell, a rechargeable secondary cell, or a fuel cell, for example. At least a part of the battery 350 may be arranged on substantially the same plane with the printed circuit board 340, for example. The battery 350 may be arranged integrally inside the electronic device 300, or may be arranged such that the same can be attached to/detached from the electronic device 300.

The antenna 370 may be arranged between the rear plate 380 and the battery 350. The antenna 370 may include, for example, a near field communication (NFC) antenna, a wireless charging antenna, and/or a magnetic secure transmission (MST) antenna. The antenna 370 may conduct near-field communication with an external device or may wirelessly transmit/receive power necessary for charging, for example. In another embodiment, an antenna structure may be formed by a part or a combination of the side bezel structure 310 and/or the first support member 311

According to various embodiments, an electronic device 300 in FIG. 3 may be at least partially similar to the electronic device 101 in FIG. 1 or the electronic device 200 in FIG. 2A and/or FIG. 2B, or may include another embodiment of the electronic device. In an embodiment, a second support member 360 may also be omitted from the electronic device 300 in FIG. 3.

According to various embodiments, a printed circuit board (PCB) 340 may include a first PCB 340a and/or a second PCB 340b. For example, the first PCB 340a and the second PCB 340b may be arranged to be spaced apart from each other and be electrically connected using a connection member 345 (e.g., a coaxial cable and/or an FPCB). For example, the printed circuit board 340 may include a structure in which multiple printed circuit boards (PCBs) are stacked. For example, the printed circuit board 340 may include an interposer structure. In an embodiment, the printed circuit board 340 may be implemented in the form of a flexible printed circuit board (FPCB) and/or the form of a rigid printed circuit board (PCB).

According to various embodiments, a wireless communication module (e.g., the wireless communication module 192 in FIG. 1) electrically connected a processor (e.g., the processor 120 in FIG. 1) may be disposed on the printed circuit board 340.

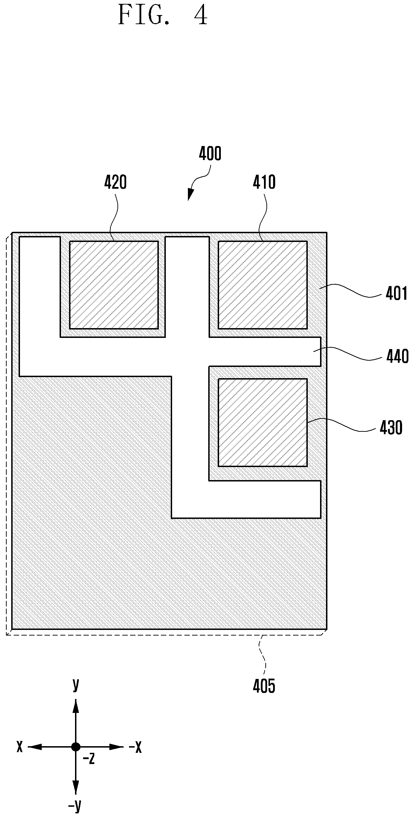

According to various embodiments, an antenna structure 400 (e.g., the antenna module 197 in FIG. 1) including at least one patch antenna (e.g., the first patch antenna 410, the second patch antenna 420, and/or the third patch antenna 430 in FIG. 4) may be disposed in one direction (e.g., the y-axis direction or the -z-axis direction) of the printed circuit board 340. For example, the antenna structure 400 may be disposed between a first support member 311 and a rear plate 380. For example, the antenna structure 400 may be disposed between a second support member 360 and the rear plate 380. The antenna structure 400 may be disposed such that the beam pattern of at least one patch antenna (e.g., the first patch antenna 410, the second patch antenna 420, and/or the third patch antenna 430 in FIG. 4) is formed in one direction (e.g., the -z-axis direction). The antenna structure 400 may be electrically connected to the printed circuit board 340. For example, at least one patch antenna included in the antenna structure 400 may be electrically connected to a wireless communication module 192 disposed on a printed circuit board 340. The antenna structure 400 may include an ultra-wideband (UWB) antenna module. At least one patch antenna (e.g., the first patch antenna 410, the second patch antenna 420, and/or the third patch antenna 430 in FIG. 4) disposed in the antenna structure 400 may operate as an ultra-wideband (UWB) antenna for transmitting and receiving a signal of a designated frequency band (e.g., about 6 GHz to 11 GHz).

FIG. 4 is a view schematically showing a configuration of an electronic device including an antenna structure and a first heat dissipation member according to an embodiment of the disclosure.

In an embodiment, FIG. 4 may be a view schematically showing an antenna structure 400 when the electronic device 300 illustrated in FIG. 3 is viewed in one direction (e.g., the - z-axis direction) according to various embodiments of the disclosure. The antenna structure 400 may include the antenna module 197 illustrated in FIG. 1.

According to an embodiment, for example, although the embodiment related to the antenna structure 400 of the electronic device 300 disclosed below is described as being applied to a bar-type electronic device, it is not limited thereto and may also be applied to an electronic device such as a foldable type of electronic device, a rollable type of electronic device, a sliding type of electronic device, a wearable type of electronic device, and/or a tablet PC.

According to an embodiment, the antenna structure 400 disclosed below may be disposed in one direction (e.g., the y-axis direction or the -z-axis direction) of the printed circuit board 340 included in the electronic device 300 illustrated in FIG. 3, or may be disposed between the first support member 311 or the second support member 360 and the rear plate 380.

Referring to FIG. 4, the antenna structure 400 (e.g., the antenna module 197 in FIG. 1) according to an embodiment of the disclosure may include a dielectric 401, a first patch antenna 410, a second patch antenna 420, a third patch antenna 430, and/or a ground layer 405.

According to an embodiment, the antenna structure 400 may also include a first heat dissipation member 440. As another example, the first heat dissipation member 440 may be formed separately and may also be disposed to overlap the dielectric 401 of the antenna structure 400.

According to an embodiment, the dielectric 401 may be a base member. For example, the dielectric 401 may include a substrate. For example, the dielectric 401 may include a flexible printed circuit board (FPCB). For example, the dielectric 401 may include multiple conductive layers, and multiple non-conductive layers alternately stacked with the conductive layers. For example, the dielectric 401 may include at least one conductive via having an electrical path formed therein. For example, the dielectric 401 may be formed of a material (e.g., modified polyimide (MPI) or liquid crystal polymer (LCP)) having low permittivity and low dielectric loss. In an embodiment, in case that the antenna structure 400 is implemented using a printed circuit board, the first patch antenna 410, the second patch antenna 420, and the third patch antenna 430 may be implemented using at least one conductive layer included in the printed circuit board, and the ground layer 405 may be a ground layer included in the printed circuit board.

According to an embodiment, the first patch antenna 410, the second patch antenna 420, and the third patch antenna 430 may be arranged on a first surface (e.g., in the -z-axis direction) of the dielectric 401 or adjacent to the first surface. The first patch antenna 410, the second patch antenna 420, and the third patch antenna 430 may be arranged such that the beam patterns thereof are formed in one direction (e.g., the -z-axis direction). In various embodiments, patch antennas arranged in the antenna structure 400 are not limited to the first patch antenna 410, the second patch antenna 420, and the third patch antenna 430 described above, and more or fewer patch antennas may also be arranged.

According to various embodiments, the first patch antenna 410 may be disposed at a corner between the -x-axis direction and the y-axis direction of the dielectric 401. The second patch antenna 420 may be disposed in the x-axis direction of the first patch antenna 410. The third patch antenna 430 may be disposed in the -y-axis direction of the first patch antenna 410. The first patch antenna 410, the second patch antenna 420, and the third patch antenna 430 may be electrically connected to a wireless communication module (e.g., the wireless communication module 192 in FIG. 1) and may receive a feeding signal transmitted therefrom.

According to an embodiment, the first patch antenna 410, the second patch antenna 420, and the third patch antenna 430 may receive a feeding signal transmitted from a wireless communication module (e.g., the wireless communication module 192 in FIG. 1) through at least one of, for example, a strip line, a micro strip line, a co-planar waveguide (CPW), and a via.

According to an embodiment, the first patch antenna 410 and the second patch antenna 420 may transmit and/or receive a first polarization (e.g., a horizontal polarization) signal (e.g., in the direction parallel to the x-axis and the -x-axis). The first patch antenna 410 and the third patch antenna 430 may transmit and/or receive a second polarization (e.g., a vertical polarization) signal (e.g., in the direction parallel to the y-axis and the -y-axis).

According to an embodiment, the ground layer 405 may be disposed on a second surface (e.g., in the z-axis direction) of the dielectric 401. For example, when viewed in the z-axis direction, the ground layer 405 may be disposed to overlap the first patch antenna 410, the second patch antenna 420, and the third patch antenna 430.

According to an embodiment, the first heat dissipation member 440 may be disposed to surround at least parts of the first patch antenna 410, the second patch antenna 420, and the third patch antenna 430. For example, the first heat dissipation member 440 may be disposed on the dielectric 401 to surround at least parts of the first patch antenna 410, the second patch antenna 420, and the third patch antenna 430. In an embodiment, the first heat dissipation member 440 may be coupled to at least one of the first patch antenna 410, the second patch antenna 420, and the third patch antenna 430 so as to operate as an antenna radiation body. For example, the first heat dissipation member 440 may operate as an antenna radiation body by using an electric field coupled to at least one of the first patch antenna 410, the second patch antenna 420, and the third patch antenna 430. The first heat dissipation member 440 may be positioned at a position at which at least one of the first patch antenna 410, the second patch antenna 420, and the third patch antenna 430 is couplable.

According to an embodiment, the first heat dissipation member 440 may include a graphite sheet, a copper (CU) sheet, or an aluminum (AL) sheet having excellent heat diffusion performance and heat transfer performance in order to transfer heat generated from the antenna radiation body 400 and the electronic device 300 to another region. According to various embodiments, the first heat dissipation member 440 may also include a heat dissipation plate, a shield can, a heat sink, a vapor chamber, or a heat pipe.

According to various embodiments, the first heat dissipation member 440 may be disposed to surround at least a part in the -y-axis direction and the x-axis direction of the first patch antenna 410. The first heat dissipation member 440 may be disposed to surround at least a part in the -x-axis direction, the -y-axis direction, and the x-axis direction of the second patch antenna 420. The first heat dissipation member 440 may be disposed to surround at least a part in the -y-axis direction, the x-axis direction, and the y-axis direction of the third patch antenna 430. According to an embodiment, the first heat dissipation member 440 and at least one of the first patch antenna 410, the second patch antenna 420, and the third patch antenna 430 may have improved or enhanced bandwidths through the higher-order mode resonance by coupling. At least one of the first patch antenna 410, the second patch antenna 420, and the third patch antenna 430 may be coupled to the first heat dissipation member 440 so that the radiation performance thereof is improved or enhanced.

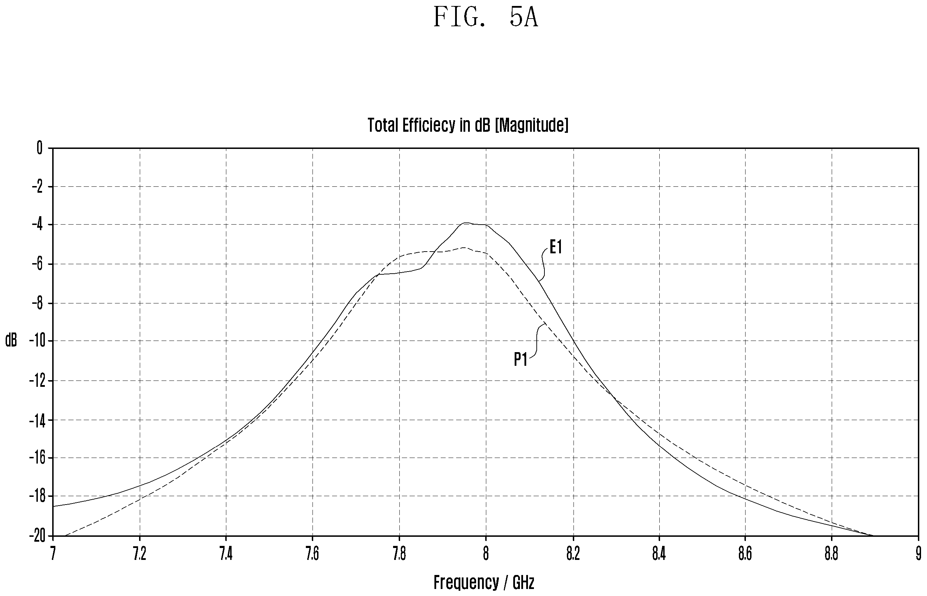

FIG. 5A is a view showing the radiation efficiency of a first patch antenna having at least a part surrounded by a first heat dissipation member of an electronic device according to an embodiment of the disclosure, and the radiation efficiency of a patch antenna according to a comparative embodiment.

For example, as illustrated in FIG. 4, the first patch antenna 410 disposed in the antenna structure 400 of the electronic device 300 according to an embodiment of the disclosure may have at least a part in the -y-axis direction and the x-axis direction surrounded by the first heat dissipation member 440.

For example, an electronic device according to a comparative embodiment may include only the first patch antenna 410 disposed on the dielectric 401, and may include the first heat dissipation member 440 according to an embodiment of the disclosure, which is not disposed to surround at least a part of the first patch antenna 410.

Referring to FIG. 5A, it can be identified that the radiation efficiency E1 of the first patch antenna 410 according to an embodiment of the disclosure, which uses the first heat dissipation member 440 resonating through coupling with the first patch antenna 410 as an antenna radiation body, is improved compared to the radiation efficiency P1 of the first patch antenna 410 according to the comparative embodiment in which the first heat dissipation member 440 is not disposed. For example, it can be identified that the radiation efficiency E1 of the first patch antenna 410 having at least a part surrounded by the first heat dissipation member 440 according to an embodiment of the disclosure is improved compared to the radiation efficiency P1 of the first patch antenna 410 according to the comparative embodiment, in the bands of about 7 GHz to 7.75 GHz and about 7.83 GHz to 8.3 GHz.

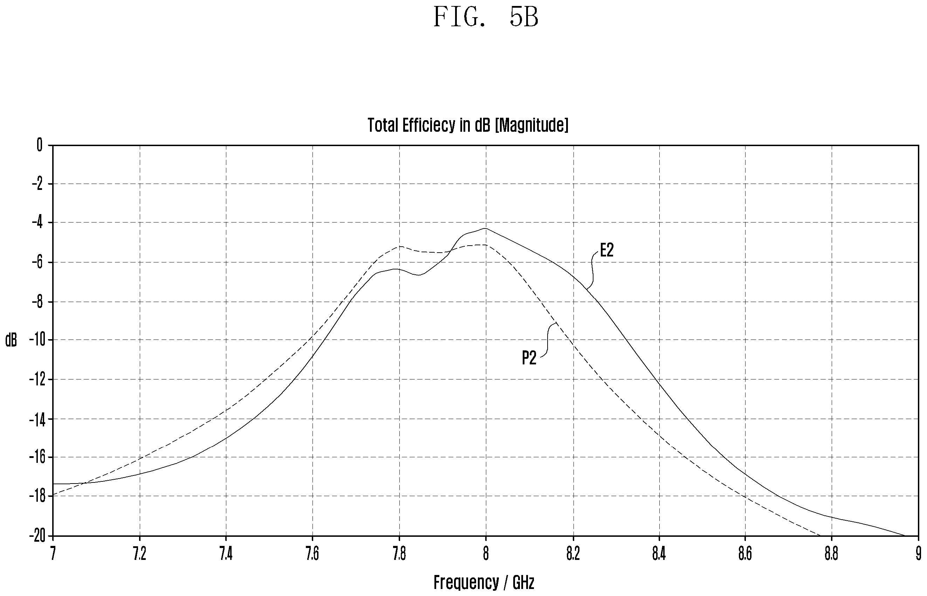

FIG. 5B is a view showing the radiation efficiency of a second patch antenna having at least a part surrounded by a first heat dissipation member of an electronic device according to an embodiment of the disclosure, and the radiation efficiency of a patch antenna according to a comparative embodiment.

For example, as illustrated in FIG. 4, the second patch antenna 420 disposed in the antenna structure 400 of the electronic device 300 according to an embodiment of the disclosure may have at least a part in the -x-axis direction, the -y-axis direction, and the x-axis direction surrounded by the first heat dissipation member 440.

For example, an electronic device according to a comparative embodiment may include only the second patch antenna 420 disposed on the dielectric 401, and may include the first heat dissipation member 440 according to an embodiment of the disclosure, which is not disposed to surround at least a part of the second patch antenna 420.

Referring to FIG. 5B, it can be identified that the radiation efficiency E2 of the second patch antenna 420 according to an embodiment of the disclosure, which uses the first heat dissipation member 440 resonating through coupling with the second patch antenna 420 as an antenna radiation body, is improved compared to the radiation efficiency P2 of the second patch antenna 420 according to the comparative embodiment in which the first heat dissipation member 440 is not disposed. For example, it can be identified that the radiation efficiency E2 of the second patch antenna 420 having at least a part surrounded by the first heat dissipation member 440 according to an embodiment of the disclosure is improved compared to the radiation efficiency P2 of the second patch antenna 420 according to the comparative embodiment, in the band of about 7.9 GHz to 8.9 GHz.

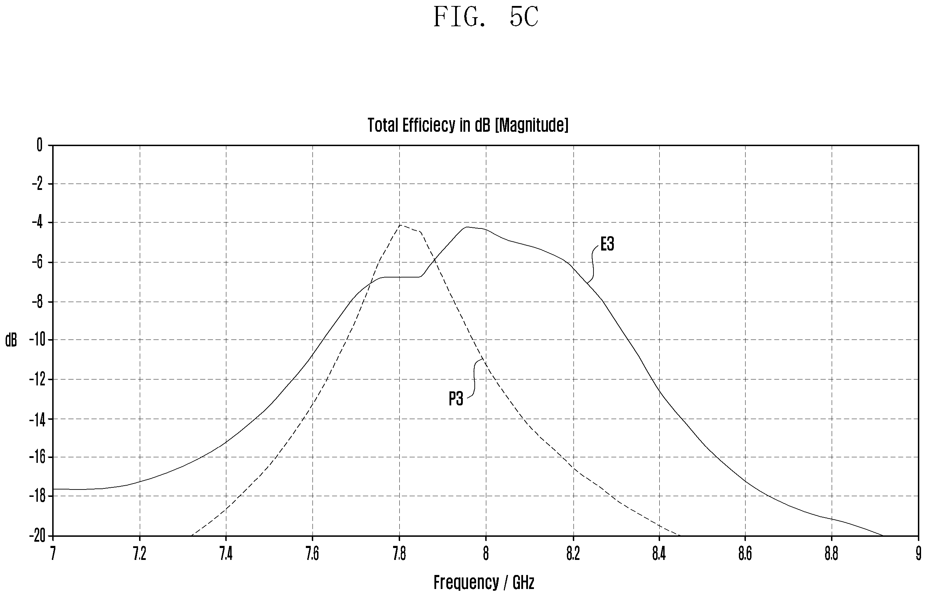

FIG. 5C is a view showing the radiation efficiency of a third patch antenna having at least a part surrounded by a first heat dissipation member of an electronic device according to an embodiment of the disclosure, and the radiation efficiency of a patch antenna according to a comparative embodiment.

For example, as illustrated in FIG. 4, the third patch antenna 430 disposed in the antenna structure 400 of the electronic device 300 according to an embodiment of the disclosure may have at least a part in the -y-axis direction, the x-axis direction, and the y-axis direction surrounded by the first heat dissipation member 440.

For example, an electronic device according to a comparative embodiment may include only the third patch antenna 430 disposed on the dielectric 401, and may include the first heat dissipation member 440 according to an embodiment of the disclosure, which is not disposed to surround at least a part of the third patch antenna 430.

Referring to FIG. 5C, it can be identified that the radiation efficiency E3 of the third patch antenna 430 according to an embodiment of the disclosure, which uses the first heat dissipation member 440 resonating through coupling with the third patch antenna 430 as an antenna radiation body, is improved compared to the radiation efficiency P3 of the third patch antenna 430 according to the comparative embodiment in which the first heat dissipation member 440 is not disposed. For example, it can be identified that the radiation efficiency E3 of the third patch antenna 430 having at least a part surrounded by the first heat dissipation member 440 according to an embodiment of the disclosure is improved compared to the radiation efficiency P3 of the third patch antenna 430 according to the comparative embodiment, in the bands of about 7 GHz to 7.7 GHz and about 7.83 GHz to 8.9 GHz.

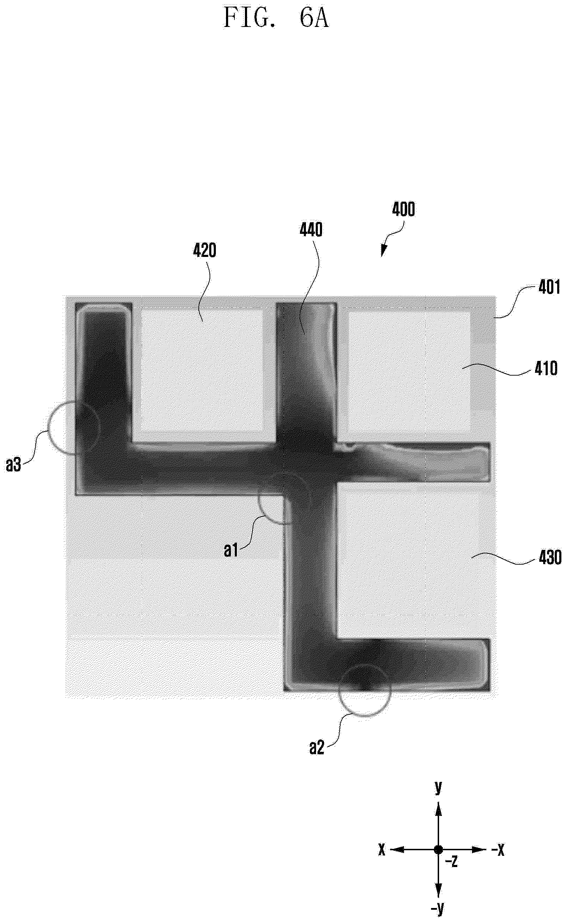

FIG. 6A is a view showing an electric field distribution of a first heat dissipation member when a first patch antenna operates, in an electronic device according to an embodiment of the disclosure.

Referring to FIG. 6A, in case that the first patch antenna 410 included in the antenna structure 400 operates, it can be identified that a part of the first heat dissipation member 440, which surrounds the first patch antenna 410, operates as an antenna radiation body.

According to an embodiment, a point, at which the electric field generated from the first patch antenna 410 is zero when the first patch antenna 410 operates, may be identified at a part of the first heat dissipation member 440. For example, the point, at which the electric field of the first heat dissipation member 440 is zero when the first patch antenna 410 operates, may include a first point a1 between the second patch antenna 420 and the third patch antenna 430 (e.g., between the x-axis and the -y-axis), a second point a2 in the -y-axis direction of the third patch antenna 430, and a third point a3 in the x-axis direction of the second patch antenna 420.

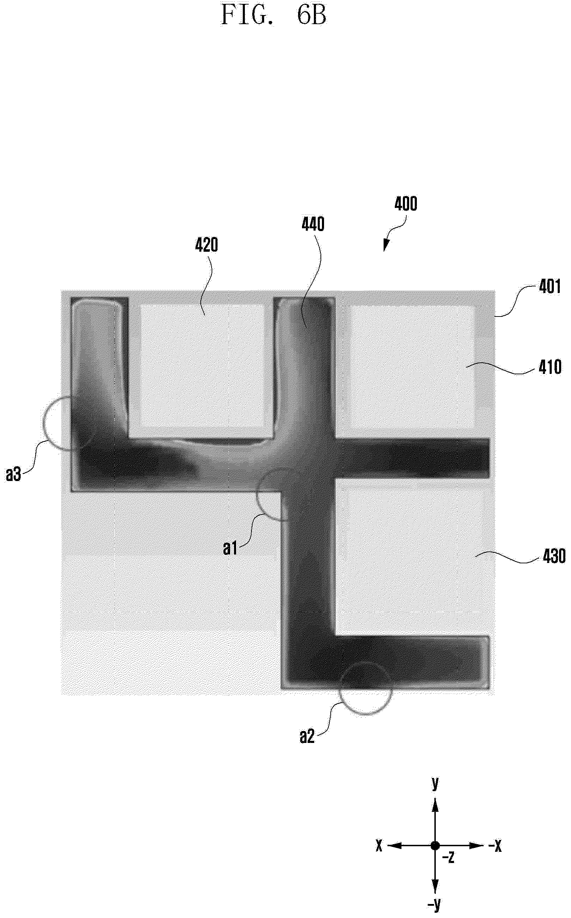

FIG. 6B is a view showing an electric field distribution of a first heat dissipation member when a second patch antenna operates, in an electronic device according to an embodiment of the disclosure.

Referring to FIG. 6B, in case that the second patch antenna 420 included in the antenna structure 400 operates, it can be identified that a part of the first heat dissipation member 440, which surrounds the second patch antenna 420, operates as an antenna radiation body.

According to an embodiment, a point, at which the electric field generated from the second patch antenna 420 is zero when the second patch antenna 420 operates, may be identified at a part of the first heat dissipation member 440. For example, the point, at which the electric field of the first heat dissipation member 440 is zero when the second patch antenna 420 operates, may include the first point a1 between the second patch antenna 420 and the third patch antenna 430 (e.g., between the x-axis and the -y-axis), the second point a2 in the -y-axis direction of the third patch antenna 430, and the third point a3 in the x-axis direction of the second patch antenna 420.

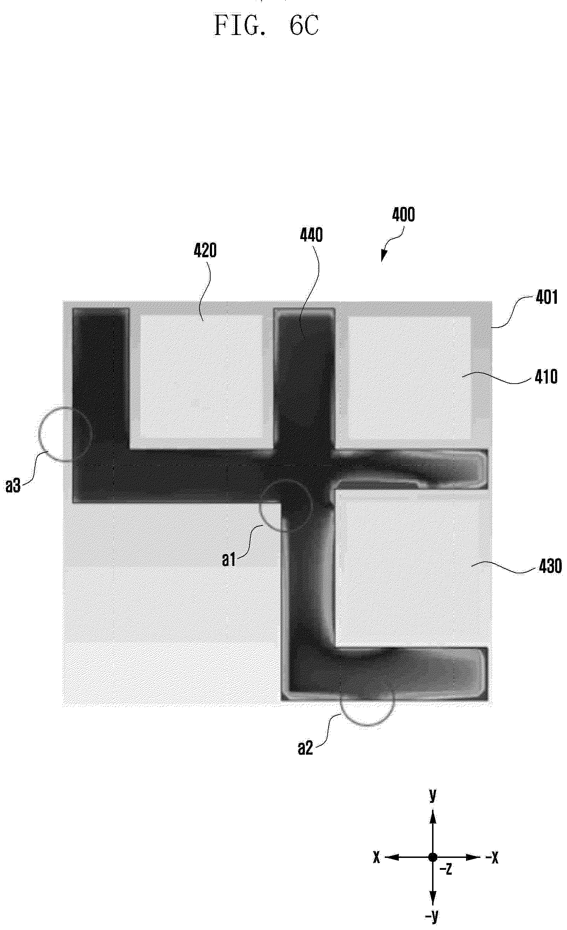

FIG. 6C is a view showing an electric field distribution of a first heat dissipation member when a third patch antenna operates, in an electronic device according to an embodiment of the disclosure.

Referring to FIG. 6C, in case that the third patch antenna 430 included in the antenna structure 400 operates, it can be identified that a part of the first heat dissipation member 440, which surrounds the third patch antenna 430, operates as an antenna radiation body.

According to an embodiment, a point, at which the electric field generated from the third patch antenna 430 is zero when the third patch antenna 430 operates, may be identified at a part of the first heat dissipation member 440. For example, the point, at which the electric field of the first heat dissipation member 440 is zero when the third patch antenna 430 operates, may include the first point a1 between the second patch antenna 420 and the third patch antenna 430 (e.g., between the x-axis and the -y-axis), the second point a2 in the -y-axis direction of the third patch antenna 430, and the third point a3 in the x-axis direction of the second patch antenna 420.

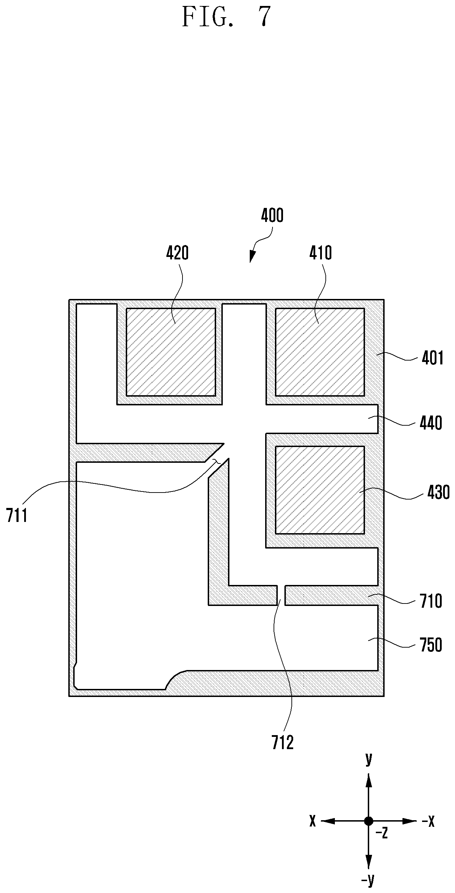

FIG. 7 is a view schematically showing a configuration of an electronic device including an antenna structure, a first heat dissipation member, and a second heat dissipation member according to an embodiment of the disclosure.

According to various embodiments, an antenna structure 400 illustrated in FIG. 7 may include the embodiments illustrated in FIG. 4 and FIG. 6A to FIG. 6C. In the description of the antenna structure 400 disclosed below, the same reference numerals are given to elements substantially identical to those of the embodiments illustrated in FIG. 4 and FIG. 6A to FIG. 6C, and the overlapping descriptions for functions thereof may be omitted.

Referring to FIG. 7, the antenna structure 400 according to an embodiment of the disclosure may include a dielectric 401, a first patch antenna 410, a second patch antenna 420, and/or a third patch antenna 430.

According to an embodiment, the antenna structure 400 may also further include a first heat dissipation member 440 and/or a second heat dissipation member 750. As another example, at least one of the first heat dissipation member 440 and the second heat dissipation member 750 may be formed separately and may also be disposed to overlap the dielectric 401 of the antenna structure 400.

According to an embodiment, the first patch antenna 410, the second patch antenna 420, and the third patch antenna 430 may be arranged on a first surface (e.g., in the -z-axis direction) of the dielectric 401 or adjacent to the first surface.

According to an embodiment, the first patch antenna 410 may be disposed at a corner between the -x-axis direction and the y-axis direction of the antenna structure 400. The second patch antenna 420 may be disposed in the x-axis direction of the first patch antenna 410. The third patch antenna 430 may be disposed in the -y-axis direction of the first patch antenna 410. The first patch antenna 410, the second patch antenna 420, and the third patch antenna 430 may be electrically connected to a wireless communication module (e.g., the wireless communication module 192 in FIG. 1) and may receive a feeding signal transmitted therefrom.

According to an embodiment, the first heat dissipation member 440 may be disposed to surround at least parts of the first patch antenna 410, the second patch antenna 420, and the third patch antenna 430. For example, the first heat dissipation member 440 may be coupled to at least one of the first patch antenna 410, the second patch antenna 420, and the third patch antenna 430 so as to operate as an antenna radiation body. For example, the first heat dissipation member 440 may operate as an antenna radiation body by using an electric field coupled to at least one of the first patch antenna 410, the second patch antenna 420, and the third patch antenna 430.

According to various embodiments, the first heat dissipation member 440 may be disposed to surround at least a part in the -y-axis direction and the x-axis direction of the first patch antenna 410. The first heat dissipation member 440 may be disposed to surround at least a part in the -x-axis direction, the -y-axis direction, and the x-axis direction of the second patch antenna 420. The first heat dissipation member 440 may be disposed to surround at least a part in the -y-axis direction, the x-axis direction, and the y-axis direction of the third patch antenna 430. At least one of the first patch antenna 410, the second patch antenna 420, and the third patch antenna 430 may be coupled to the first heat dissipation member 440 so that the radiation performance thereof is improved or enhanced.

According to an embodiment, the second heat dissipation member 750 may be disposed to surround at least a part of the first heat dissipation member 440. For example, the second heat dissipation member 750 may be disposed adjacent to the first heat dissipation member 440. The second heat dissipation member 750 may transfer and diffuse heat generated from the antenna structure 400 and the electronic device 300 to another region. For example, the second heat dissipation member 750 may be disposed between the second support member 360 and the antenna 370 illustrated in FIG. 3. For example, the second heat dissipation member 750 may also be disposed on the dielectric 401 of the antenna structure 400. In an embodiment, the second heat dissipation member 750 may be separated or spaced from the first heat dissipation member 440 by a non-conductive pattern 710 (e.g., a part of the dielectric 401 or a slit).

According to an embodiment, the non-conductive pattern 710 (e.g., a part of the dielectric 401) may be formed between the first heat dissipation member 440 and the second heat dissipation member 750. For example, the non-conductive pattern 710 may be formed in the -y-axis direction and the x-axis direction of the third patch antenna 430 and in the -y-axis direction of the second patch antenna 420.

According to an embodiment, the first heat dissipation member 440 and the second heat dissipation member 750 may be connected through at least one of a first connection part 711 and a second connection part 712. For example, the first connection part 711 and the second connection part 712 may be conductive paths connecting the first heat dissipation member 440 and the second heat dissipation member 750. At least one of the first connection part 711 and the second connection part 712 may be disposed at a designated position of the non-conductive pattern 710. For example, as illustrated in FIG. 6A to FIG. 6C, the first connection part 711 and the second connection part 712 may be formed at points at which the electric fields generated from one or more of the first patch antenna 410, the second patch antenna 420, and the third patch antenna 430 are zero when one or more of the first patch antenna 410, the second patch antenna 420, and the third patch antenna 430 operate. For example, the first connection part 711 may be formed at a first point a1 between the second patch antenna 420 and the third patch antenna 430 (e.g., between the x-axis and the -y-axis). For example, the second connection part 712 may be formed at a second point a2 of the -y-axis direction of the third patch antenna 430.

According to an embodiment, the second heat dissipation member 750 may be connected to the first heat dissipation member 440 through at least one of the first connection part 711 and the second connection part 712, and may diffuse and transfer heat transferred from the first heat dissipation member 750 to another region. The second heat dissipation member 750 may be connected to the first heat dissipation member 440 through at least one of the first connection part 711 and the second connection part 712, so that the heat dissipation area of the electronic device 300 is increased and the heat dissipation efficiency thereof is improved. In an embodiment, the second heat dissipation member 750 may include a graphite sheet, a copper (CU) sheet, or an aluminum (AL) sheet having excellent heat diffusion performance and heat transfer performance. In various embodiments, the second heat dissipation member 750 may also include a heat dissipation plate, a shield can, a heat sink, a vapor chamber, or a heat pipe. In an embodiment, the first connection part 711 and/or the second connection part 712 may include the same material as the first heat dissipation member 440 or the second heat dissipation member 750.

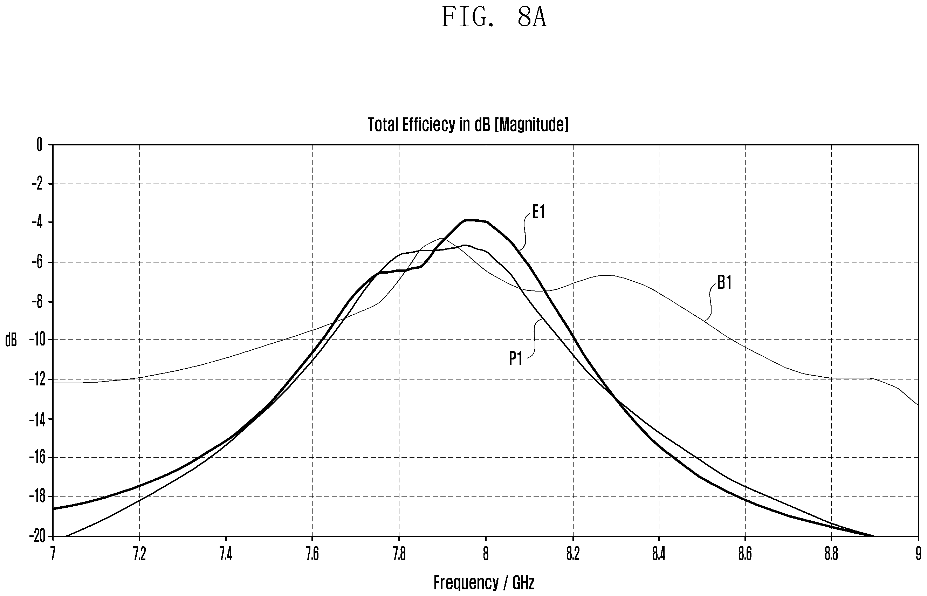

FIG. 8A is a view showing the radiation efficiency of a first patch antenna in case that a first heat dissipation member and a second heat dissipation member are connected through at least one connection part, in an electronic device according to an embodiment of the disclosure, the radiation efficiency of the first patch antenna according to a first comparative embodiment, and the radiation efficiency of the first patch antenna according to a second comparative embodiment.

For example, as illustrated in FIG. 7, the antenna structure 400 of the electronic device 300 according to an embodiment of the disclosure may be configured such that the first heat dissipation member 440 and the second heat dissipation member 750 are connected through at least one of the first connection part 711 and the second connection part 712.

For example, an electronic device according to a first comparative embodiment may be configured such that the first heat dissipation member 440 and/or the second heat dissipation member 750 is disposed so as not to surround the first patch antenna 410, the second patch antenna 420, and the third patch antenna 430, and is disposed at a position spaced apart from the patch antennas, the position being a position at which the coupling with the patch antennas does not occur.

For example, an electronic device according to a second comparative embodiment may be configured such that the first heat dissipation member 440 and the second heat dissipation member 750 are not separated by the non-conductive pattern 710 (e.g., a part of the dielectric 401) according to an embodiment of the disclosure, are formed as one, and surround at least parts of the first patch antenna 410, the second patch antenna 420, and the third patch antenna 430. In addition, the first heat dissipation member 440 and the second heat dissipation member 750 may be coupled to the first patch antenna 410, the second patch antenna 420, and the third patch antenna 430.

Referring to FIG. 8A, it can be identified that the radiation efficiency E1 of the first patch antenna 410 according to an embodiment of the disclosure, which uses the first heat dissipation member 440 resonating through coupling with the first patch antenna 410 as an antenna radiation body and in which the first heat dissipation member 440 and the second heat dissipation member 750 are connected through at least one of the first connection part 711 and the second connection part 712, is improved compared to the radiation efficiency P1 of the first patch antenna 410 according to the first comparative embodiment and the radiation efficiency B1 of the first patch antenna 410 according to the second comparative embodiment. For example, the first patch antenna 410 according to an embodiment of the disclosure, which uses the first heat dissipation member 440 resonating through coupling with the first patch antenna 410 as an antenna radiation body and in which the first heat dissipation member 440 and the second heat dissipation member 750 are connected through at least one of the first connection part 711 and the second connection part 712, may have a resonant frequency in the band of about 7.8 GHz to 8.1 GHz, and it can be identified that the radiation efficiency E1 thereof is improved compared to the radiation efficiency P1 of the first patch antenna 410 according to the first comparative embodiment and the radiation efficiency B1 of the first patch antenna 410 according to the second comparative embodiment, in the band of about 7.9 GHz to 8.15 GHz.

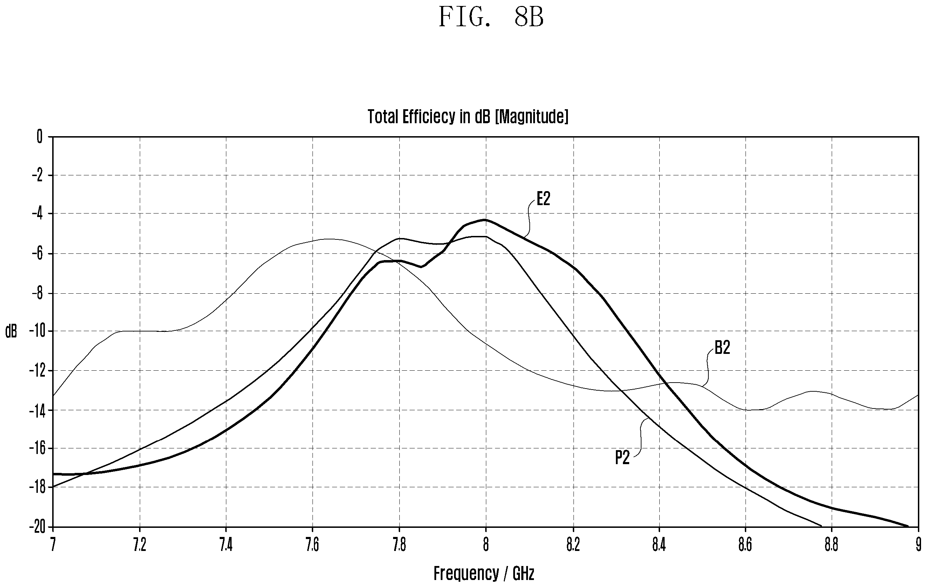

FIG. 8B is a view showing the radiation efficiency of a second patch antenna in case that a first heat dissipation member and a second heat dissipation member are connected through at least one connection part, in an electronic device according to an embodiment of the disclosure, the radiation efficiency of the second patch antenna according to a first comparative embodiment, and the radiation efficiency of the second patch antenna according to a second comparative embodiment.

For example, as illustrated in FIG. 7, the antenna structure 400 of the electronic device 300 according to an embodiment of the disclosure may be configured such that the first heat dissipation member 440 and the second heat dissipation member 750 are connected through at least one of the first connection part 711 and the second connection part 712.

For example, an electronic device according to a first comparative embodiment may be configured such that the first heat dissipation member 440 and/or the second heat dissipation member 750 is disposed so as not to surround the first patch antenna 410, the second patch antenna 420, and the third patch antenna 430, and is disposed at a position spaced apart from the patch antennas, the position being a position at which the coupling with the patch antennas does not occur.

For example, an electronic device according to a second comparative embodiment may be configured such that the first heat dissipation member 440 and the second heat dissipation member 750 are not separated by the non-conductive pattern 710 (e.g., a part of the dielectric 401) according to an embodiment of the disclosure, are formed as one, and surround at least parts of the first patch antenna 410, the second patch antenna 420, and the third patch antenna 430. In addition, the first heat dissipation member 440 and the second heat dissipation member 750 may be coupled to the first patch antenna 410, the second patch antenna 420, and the third patch antenna 430.

Referring to FIG. 8B, it can be identified that the radiation efficiency E2 of the second patch antenna 420 according to an embodiment of the disclosure, which uses the first heat dissipation member 440 resonating through coupling with the second patch antenna 420 as an antenna radiation body and in which the first heat dissipation member 440 and the second heat dissipation member 750 are connected through at least one of the first connection part 711 and the second connection part 712, is improved compared to the radiation efficiency P2 of the second patch antenna 420 according to the first comparative embodiment and the radiation efficiency B2 of the second patch antenna 420 according to the second comparative embodiment. For example, the second patch antenna 420 according to an embodiment of the disclosure, which uses the first heat dissipation member 440 resonating through coupling with the second patch antenna 420 as an antenna radiation body and in which the first heat dissipation member 440 and the second heat dissipation member 750 are connected through at least one of the first connection part 711 and the second connection part 712, may have a resonant frequency in the band of about 7.8 GHz to 8.2 GHz, and it can be identified that the radiation efficiency E2 thereof is improved compared to the radiation efficiency P2 of the second patch antenna 420 according to the first comparative embodiment and the radiation efficiency B2 of the second patch antenna 420 according to the second comparative embodiment, in the band of about 7.9 GHz to 8.4 GHz.

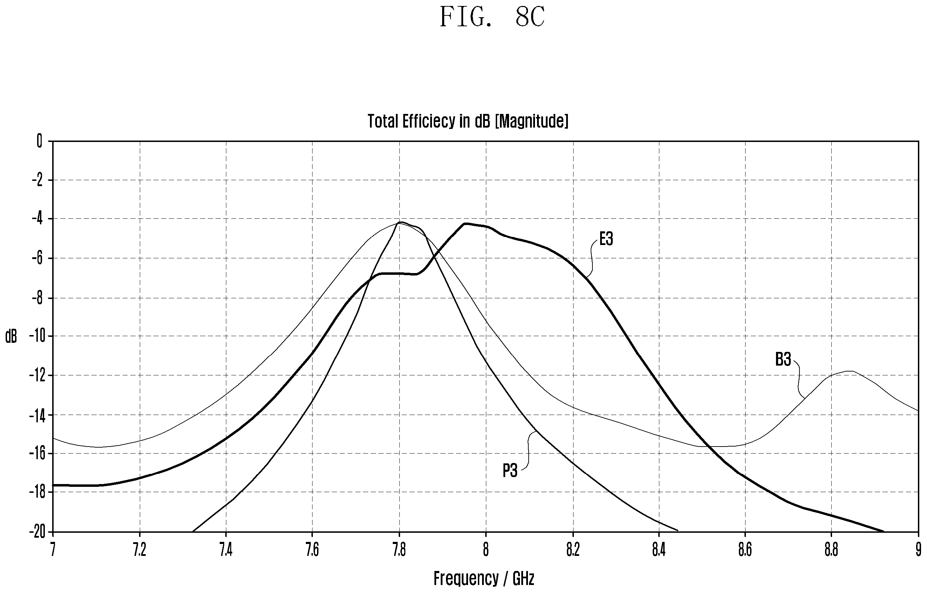

FIG. 8C is a view showing the radiation efficiency of a third patch antenna in case that a first heat dissipation member and a second heat dissipation member are connected through at least one connection part, in an electronic device according to an embodiment of the disclosure, the radiation efficiency of the third patch antenna according to a first comparative embodiment, and the radiation efficiency of the third patch antenna according to a second comparative embodiment.

For example, as illustrated in FIG. 7, the antenna structure 400 of the electronic device 300 according to an embodiment of the disclosure may be configured such that the first heat dissipation member 440 and the second heat dissipation member 750 are connected through at least one of the first connection part 711 and the second connection part 712.

For example, an electronic device according to a first comparative embodiment may be configured such that the first heat dissipation member 440 and/or the second heat dissipation member 750 is disposed so as not to surround the first patch antenna 410, the second patch antenna 420, and the third patch antenna 430, and is disposed at a position spaced apart from the patch antennas, the position being a position at which the coupling with the patch antennas does not occur.

For example, an electronic device according to a second comparative embodiment may be configured such that the first heat dissipation member 440 and the second heat dissipation member 750 are not separated by the non-conductive pattern 710 (e.g., a part of the dielectric 401) according to an embodiment of the disclosure, are formed as one, and surround at least parts of the first patch antenna 410, the second patch antenna 420, and the third patch antenna 430. In addition, the first heat dissipation member 440 and the second heat dissipation member 750 may be coupled to the first patch antenna 410, the second patch antenna 420, and the third patch antenna 430.

Referring to FIG. 8C, it can be identified that the radiation efficiency E3 of the third patch antenna 430 according to an embodiment of the disclosure, which uses the first heat dissipation member 440 resonating through coupling with the third patch antenna 430 as an antenna radiation body and in which the first heat dissipation member 440 and the second heat dissipation member 750 are connected through at least one of the first connection part 711 and the second connection part 712, is improved compared to the radiation efficiency P3 of the third patch antenna 430 according to the first comparative embodiment and the radiation efficiency B3 of the third patch antenna 430 according to the second comparative embodiment. For example, the third patch antenna 430 according to an embodiment of the disclosure, which uses the first heat dissipation member 440 resonating through coupling with the third second antenna 430 as an antenna radiation body and in which the first heat dissipation member 440 and the second heat dissipation member 750 are connected through at least one of the first connection part 711 and the second connection part 712, may have a resonant frequency in the band of about 7.8 GHz to 8.2 GHz, and it can be identified that the radiation efficiency E3 thereof is improved compared to the radiation efficiency P3 of the third patch antenna 430 according to the first comparative embodiment and the radiation efficiency B3 of the third patch antenna 430 according to the second comparative embodiment, in the band of about 7.9 GHz to 8.5 GHz.

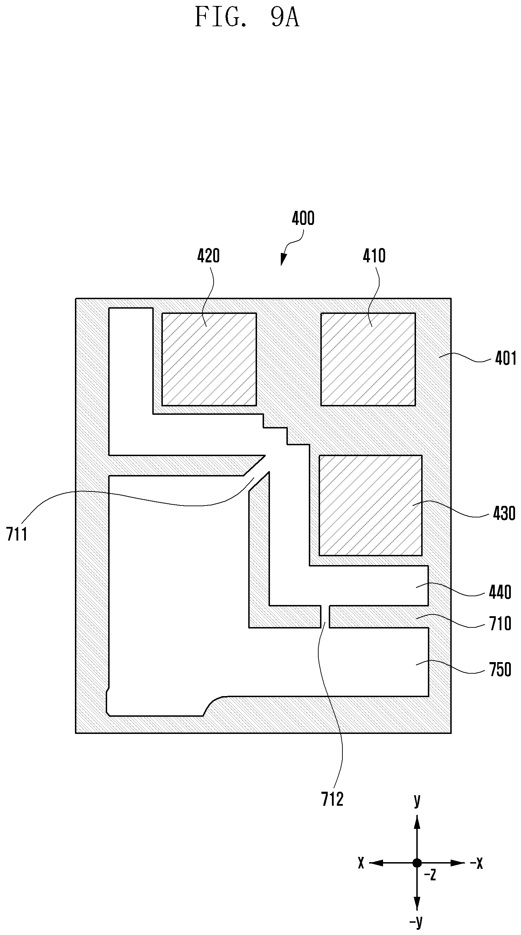

FIG. 9A is a view showing a configuration in which a second patch antenna and a third patch antenna included in an antenna structure are surrounded by a first heat dissipation member, in an electronic device according to an embodiment of the disclosure.

According to various embodiments, the view of an antenna structure 400 illustrated in FIG. 9A may show various embodiments of the antenna structure 400 illustrated in FIG. 7. In the description of the antenna structure 400 illustrated in FIG. 9A, the same reference numerals are given to elements substantially identical to those of the embodiment illustrated in FIG. 7, and the overlapping descriptions for functions thereof may be omitted.

Referring to FIG. 9A, the antenna structure 400 according to an embodiment of the disclosure may be disposed such that the first heat dissipation member 440 surrounds at least one of the second patch antenna 420 and the third patch antenna 430. For example, the first heat dissipation member 440 may be disposed to surround the second patch antenna 420 in the -y-axis direction and the x-axis direction and the third patch antenna 430 in the -y-axis direction and the x-axis direction. For example, the first patch antenna 410 may be surrounded by the dielectric 401 and may not be coupled to the first heat dissipation member 440.

According to an embodiment, the first patch antenna 410 may not be coupled to the first heat dissipation member 440, so that the frequency bandwidth thereof is not widened. At least one of the second patch antenna 420 and the third patch antenna 430 may be coupled to the first heat dissipation member 440, so that the frequency bandwidth is widened.

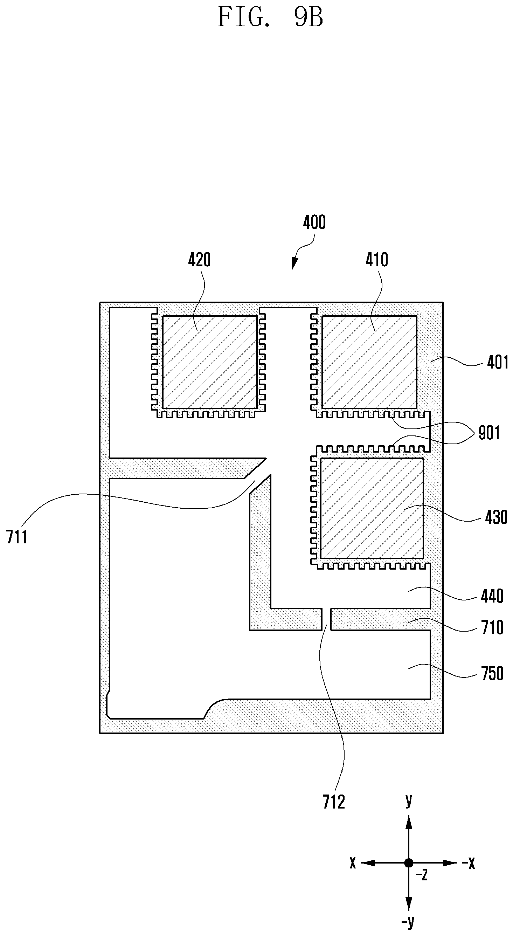

FIG. 9B is a view showing a boundary shape between a first heat dissipation member, and a first patch antenna, a second patch antenna, and a third patch antenna of an electronic device according to an embodiment of the disclosure.

According to various embodiments, the view of an antenna structure 400 illustrated in FIG. 9B may show various embodiments of the antenna structure 400 illustrated in FIG. 7. In the description of the antenna structure 400 illustrated in FIG. 9B, the same reference numerals are given to elements substantially identical to those of the embodiment illustrated in FIG. 7, and the overlapping descriptions for functions thereof may be omitted.

Referring to FIG. 9B, the antenna structure 400 according to an embodiment of the disclosure may be disposed such that the first heat dissipation member 440 surrounds at least one of the first patch antenna 410, the second patch antenna 420, and the third patch antenna 430.

According to an embodiment, the edge of the first heat dissipation member 440, which faces at least one of the first patch antenna 410, the second patch antenna 420, and the third patch antenna 430, may be formed to have a concave-convex structure 901. According to various embodiments, the edge of the first heat dissipation member 440, which faces at least one of the first patch antenna 410, the second patch antenna 420, and the third patch antenna 430, is not limited to the concave-convex structure 901 described above, and for example, may be formed in various shapes such as a zigzag shape, a wave shape, or a sawtooth shape.

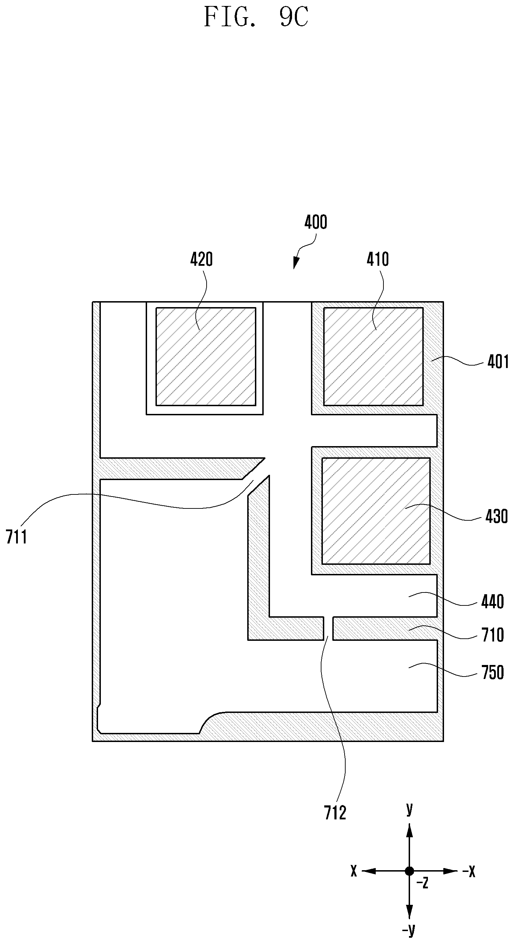

FIG. 9C is a view showing a configuration of a first heat dissipation member and a second heat dissipation member arranged in an antenna structure of an electronic device according to an embodiment of the disclosure.

According to various embodiments, the view of an antenna structure 400 illustrated in FIG. 9C may show various embodiments of the antenna structure 400 illustrated in FIG. 7. In the description of the antenna structure 400 illustrated in FIG. 9C, the same reference numerals are given to elements substantially identical to those of the embodiment illustrated in FIG. 7, and the overlapping descriptions for functions thereof may be omitted.

Referring to FIG. 9C, the antenna structure 400 according to an embodiment of the disclosure may be configured such that the first patch antenna 410, the second patch antenna 420, the third patch antenna 430, the first heat dissipation member 440, and the second heat dissipation member 750 are arranged on the single dielectric 401.

According to various embodiments, the second heat dissipation member 750 may be disposed between the second support member 360 and the antenna 370 illustrated in FIG. 3. For example, the second heat dissipation member 750 may also be disposed on the dielectric 401 of the antenna structure 400. The first heat dissipation member 440 and the second heat dissipation member 750 may be connected through at least one of the first connection part 711 and the second connection part 712.

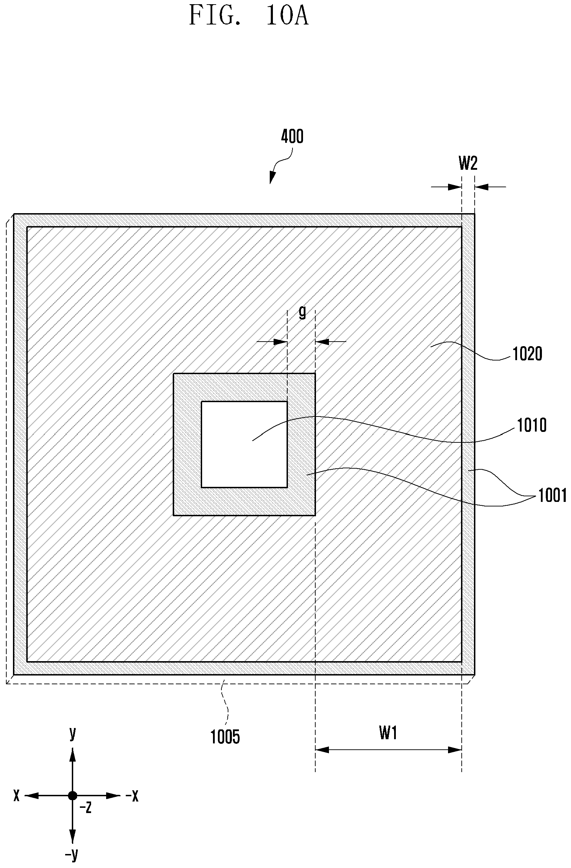

FIG. 10A is a view schematically showing a configuration of an antenna structure including a patch antenna and a heat dissipation member, in an electronic device according to an embodiment of the disclosure.

In an embodiment, FIG. 10A may be a view schematically showing an antenna structure 400 when viewed in the -z-axis direction of the electronic device 300 illustrated in FIG. 3, according to various embodiments of the disclosure.

According to an embodiment, the antenna structure 400 disclosed below may be disposed in the -z-axis direction of the printed circuit board 340 included in the electronic device 300 illustrated in FIG. 3, or may be disposed between the side surface member 310 and the rear plate 380.

Referring to FIG. 10A, the antenna structure 400 according to an embodiment of the disclosure may include a dielectric 1001, a patch antenna 1010, and/or a ground layer 1005.

According to an embodiment, the antenna structure 400 may also include a heat dissipation member 1020. As another example, the heat dissipation member 1020 may be formed separately and may also be disposed to overlap the dielectric 1001 of the antenna structure 400.

According to an embodiment, the dielectric 1001 may be a base member. For example, the dielectric 1001 may include a substrate. For example, the dielectric 1001 may include a flexible printed circuit board (FPCB). For example, the dielectric 1001 may include multiple conductive layers, and multiple non-conductive layers alternately stacked with the conductive layers. For example, the dielectric 1001 may include at least one conductive via having an electrical path formed therein. For example, the dielectric 401 may be formed of a material (e.g., modified polyimide (MPI) or liquid crystal polymer (LCP)) having low permittivity and low dielectric loss. In an embodiment, in case that the antenna structure 400 is implemented using a printed circuit board, the first patch antenna 410, the second patch antenna 420, and the third patch antenna 430 may be implemented using at least one conductive layer included in the printed circuit board, and the ground layer 405 may be a ground layer included in the printed circuit board.

According to an embodiment, the patch antenna 1010 may be disposed on a first surface (e.g., in the -z-axis direction) of the dielectric 1001 or adj acent to the first surface. For example, the patch antenna 1010 may be formed in a quadrilateral shape. The patch antenna 1010 may be disposed such that the beam pattern thereof is formed in one direction (e.g., the - z-axis direction). The patch antenna 1010 may be electrically connected to a wireless communication module (e.g., the wireless communication module 192 in FIG. 1) and thus may receive a feeding signal.

According to an embodiment, the ground layer 1005 may be disposed on a second surface (e.g., in the z-axis direction) of the dielectric 401. The ground layer 405 may overlap the patch antenna 1010.

According to an embodiment, the heat dissipation member 1020 may be disposed on the dielectric 1001 to surround the patch antenna 1010. For example, the heat dissipation member 1020 may be coupled to the patch antenna 1010 so as to act as an antenna radiation body. For example, the heat dissipation member 1020 may act as an antenna radiation body by using an electric field coupled to the patch antenna 1010. The heat dissipation member 1020 may be disposed at a position which enables the patch antenna 1010 to be coupled thereto.

According to various embodiments, the gap g between a first side surface (e.g., the x-axis direction) of the heat dissipation member 1020 and a first side surface (e.g., the -x-axis direction) of the patch antenna 1010 may be about 2 mm. The width w1 between the first side surface (e.g., the x-axis direction) of the heat dissipation member 1020 and a second side surface (e.g., the -x-axis direction) of the heat dissipation member 1020 may be formed wider than the width w2 between the second side surface (e.g., the -x-axis direction) of the heat dissipation member 1020 and a first side surface (e.g., the x-axis direction) of the outer dielectric 1001.

According to an embodiment, the heat dissipation member 1020 may include a graphite sheet, a copper (CU) sheet, or an aluminum (AL) sheet having excellent heat diffusion performance and heat transfer performance in order to transfer heat generated from the antenna structure 400 and the electronic device 300 to another region. According to various embodiments, the heat dissipation member 1020 may also include a heat dissipation plate, a shield can, a heat sink, a vapor chamber, or a heat pipe.

According to various embodiments, the patch antenna 1010 and the heat dissipation member 1020 may have improved or enhanced bandwidths through a higher-order mode resonance by coupling between the patch antenna 1010 and the heat dissipation member 1020. For example, the patch antenna 1010 may be coupled to the heat dissipation member 1020 to improve or enhance the radiation performance thereof.

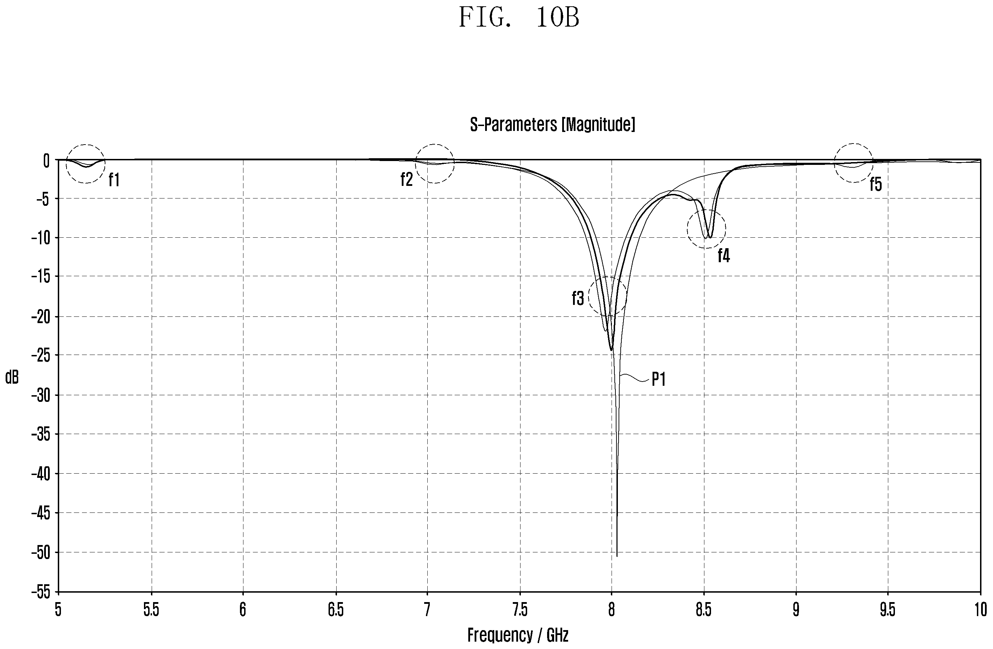

FIG. 10B is a view showing the higher-order resonant frequency in which an antenna structure uses a patch antenna and a heat dissipation member, in an electronic device according to an embodiment of the disclosure, and the resonant frequency of the patch antenna according to a comparative embodiment.

For example, as illustrated in FIG. 10A, the patch antenna 1010 disposed on the dielectric 1001 of the electronic device 300 according to an embodiment of the disclosure may be surrounded by the heat dissipation member 1020.

For example, an electronic device according to a comparative embodiment may include only the patch antenna 1010 disposed on the dielectric 1001, and may include the heat dissipation member 1020 according to an embodiment of the disclosure, which is not disposed to surround the patch antenna 1010.

Referring to FIG. 10B, it can be identified that the patch antenna 1010 according to an embodiment of the disclosure, which uses the heat dissipation member 1020 resonating through coupling with the patch antenna 1010 as an antenna radiation body, resonates in a higher-order mode (e.g., resonates in a multi-mode). For example, it can be identified that the patch antenna 1010 according to an embodiment of the disclosure surrounded by the heat dissipation member 440 has a resonant frequency in a first frequency band f1 (e.g., about 5.1 GHz to 5.2 GHz), a second frequency band f2 (e.g., about 6.9 GHz to 7.2 GHz), a third frequency band f3 (e.g., about 7.9 GHz to 8.1 GHz), a fourth frequency band f4 (e.g., about 8.4 GHz to 8.6 GHz), and a fifth frequency band f5 (e.g., about 9.3 GHz to 9.4 GHz).

According to an embodiment, it can be identified that the patch antenna 1010 according to a comparative embodiment has a resonant frequency in a designated frequency band P1 (e.g., about 8 GHz to 8.1 GHz).

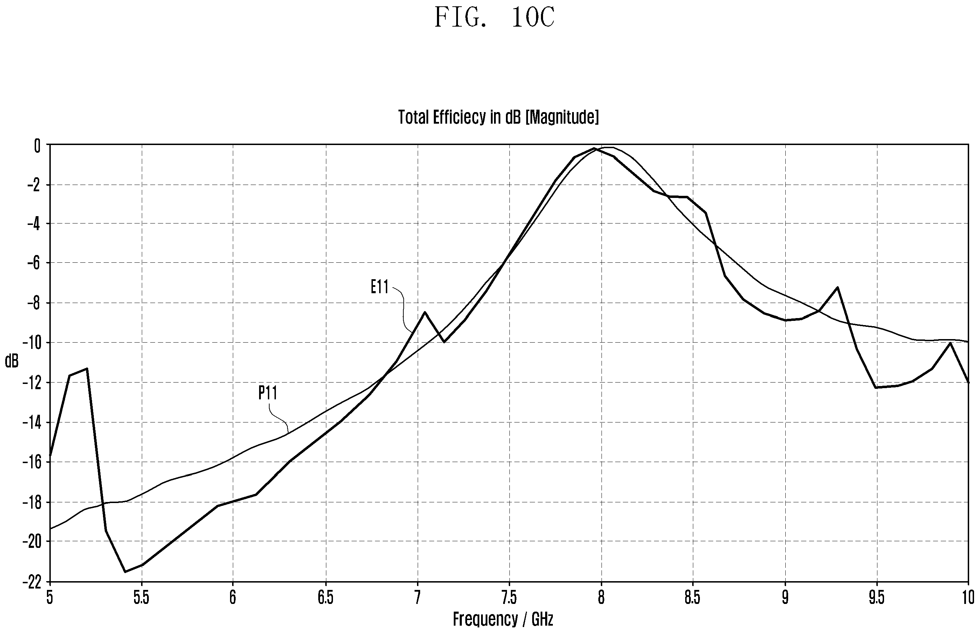

FIG. 10C is a view showing the radiation efficiency of a patch antenna surrounded by a heat dissipation member of an electronic device according to an embodiment of the disclosure, and the radiation efficiency of the patch antenna according to a comparative embodiment.

For example, as illustrated in FIG. 10A, the patch antenna 1010 disposed on the dielectric 1001 of the electronic device 300 according to an embodiment of the disclosure may be surrounded by the heat dissipation member 1020.

For example, an electronic device according to a comparative embodiment may include only the patch antenna 1010 disposed on the dielectric 1001, and may include the heat dissipation member 1020 according to an embodiment of the disclosure, which is not disposed to surround the patch antenna 1010.

Referring to FIG. 10C, it can be identified that the radiation efficiency E11 of the patch antenna 1010 according to an embodiment of the disclosure, which uses the heat dissipation member 1020 resonating through coupling with the patch antenna 1010 as an antenna radiation body, is improved compared to the radiation efficiency P11 of the patch antenna 1010 according to the comparative embodiment, which is not surrounded by the heat dissipation member 1020. For example, it can be identified that the radiation efficiency E11 of the patch antenna 1010 surrounded by the heat dissipation member 1020 according to an embodiment of the disclosure is improved compared to the radiation efficiency P11 of the patch antenna 1010 according to the comparative embodiment, in the frequency bands of about 5 GHz to 5.3 GHz, about 6.8 GHz to 7.2 GHz, about 7.6 GHz to 7.9 GHz, about 8.3 GHz to 8.6 GHz, and about 9.2 GHz to 9.3 GHz.

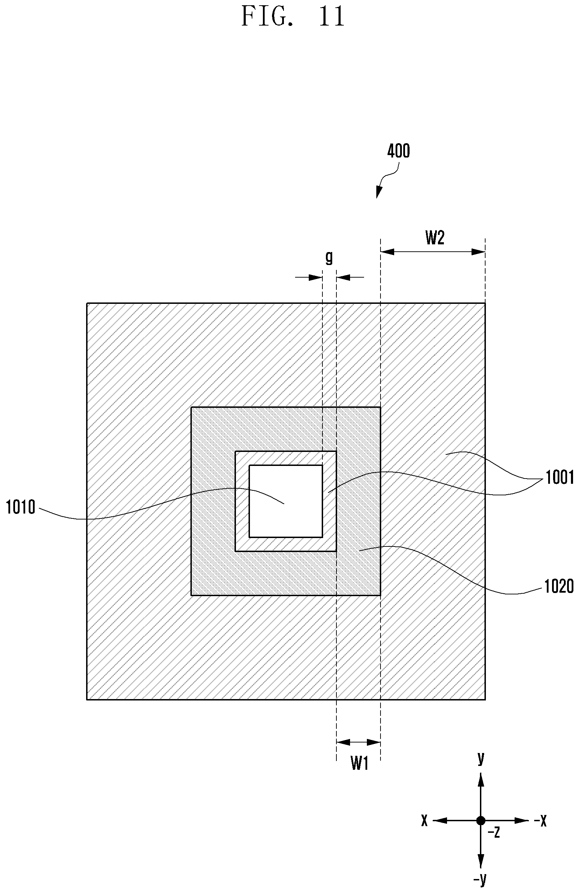

FIG. 11 is a view schematically showing a configuration of various embodiments in which an antenna structure includes a patch antenna and a heat dissipation member, in an electronic device according to an embodiment of the disclosure.

According to various embodiments, the antenna structure 400 illustrated in FIG. 11 may include the embodiment illustrated in FIG. 10A. In the description of the antenna structure 400 disclosed below, the same reference numerals are given to elements substantially identical to those of the embodiment illustrated in FIG. 10A, and the overlapping descriptions for functions thereof may be omitted.

Referring to FIG. 11, the antenna structure 400 according to an embodiment of the disclosure may include a dielectric 1001 and a patch antenna 1010.

According to an embodiment, the antenna structure 400 may also include a heat dissipation member 1020. As another example, the heat dissipation member 1020 may be formed separately and may also be disposed to overlap the dielectric 1001 of the antenna structure 400.

According to an embodiment, the patch antenna 1010 may be disposed on a first surface (e.g., in the -z-axis direction) of the dielectric 1001 or adj acent to the first surface. For example, the patch antenna 1010 may be disposed such that the beam pattern thereof is formed in one direction (e.g., the -z-axis direction). The patch antenna 1010 may be electrically connected to a wireless communication module (e.g., the wireless communication module 192 in FIG. 1) and thus may receive a feeding signal.

According to an embodiment, the heat dissipation member 1020 may be disposed on the dielectric 1001 to surround the patch antenna 1010. For example, the heat dissipation member 1020 may be coupled to the patch antenna 1010 so as to act as an antenna radiation body. The heat dissipation member 1020 may be disposed at a position which enables the patch antenna 1010 to be coupled thereto.

According to various embodiments, the gap g between a first side surface (e.g., the x-axis direction) of the heat dissipation member 1020 and a first side surface (e.g., the -x-axis direction) of the patch antenna 1010 may be about 2 mm. The width w1 between a first side surface (e.g., the x-axis direction) of the heat dissipation member 1020 and a second side surface (e.g., the -x-axis direction) of the heat dissipation member 1020 may be formed narrower than the width w2 between the second side surface (e.g., the -x-axis direction) of the heat dissipation member 1020 and one side surface (e.g., the -x-axis direction) of the outer dielectric 1001.

According to various embodiments, the patch antenna 1010 and the heat dissipation member 1020 may have improved or enhanced bandwidths through a resonance by coupling between the patch antenna 1010 and the heat dissipation member 1020. For example, the patch antenna 1010 may be coupled to the heat dissipation member 1020 to improve or enhance the radiation performance thereof.

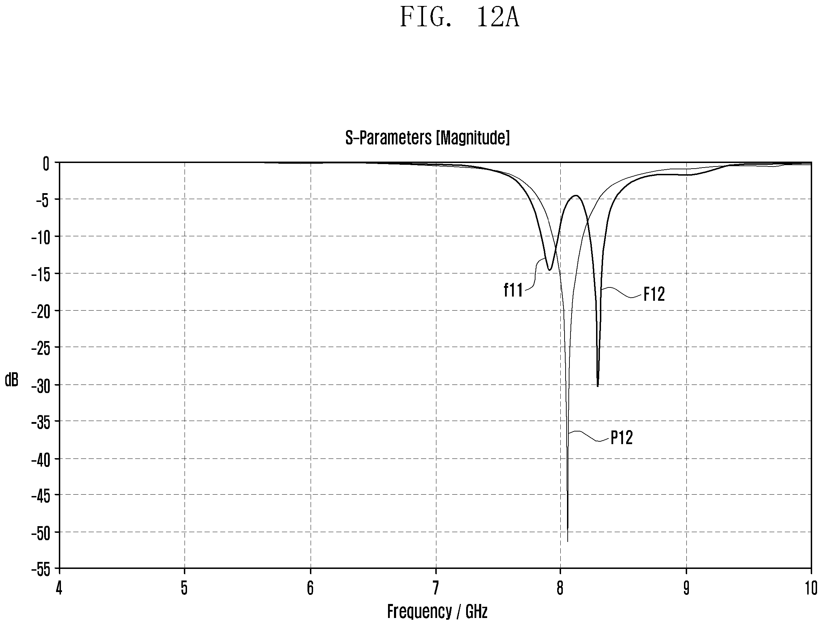

FIG. 12A is a view showing the resonant frequency of a patch antenna surrounded by a heat dissipation member of an electronic device according to an embodiment of the disclosure, and the resonant frequency of the patch antenna according to a comparative embodiment.

For example, as illustrated in FIG. 11, the patch antenna 1010 disposed on the dielectric 1001 of the electronic device 300 according to an embodiment of the disclosure may be surrounded by the heat dissipation member 1020.

For example, an electronic device according to a comparative embodiment may include only the patch antenna 1010 disposed on the dielectric 1001, and may include the heat dissipation member 1020 according to an embodiment of the disclosure, which is not disposed to surround the patch antenna 1010.

Referring to FIG. 12A, it can be identified that the patch antenna 1010 according to an embodiment of the disclosure, which uses the heat dissipation member 1020 resonating through coupling with the patch antenna 1010 as an antenna radiation body, resonates in a higher-order mode (e.g., resonates in a multi-mode). For example, it can be identified that the patch antenna 1010 according to an embodiment of the disclosure surrounded by the heat dissipation member 440 has a resonant frequency in a first frequency band f11 (e.g., about 7.8 GHz to 7.9 GHz) and a second frequency band f12 (e.g., about 8.1 GHz to 8.3 GHz).

According to an embodiment, it can be identified that the patch antenna 1010 according to a comparative embodiment has a resonant frequency in a designated frequency band P12 (e.g., about 8 GHz to 8.1 GHz).

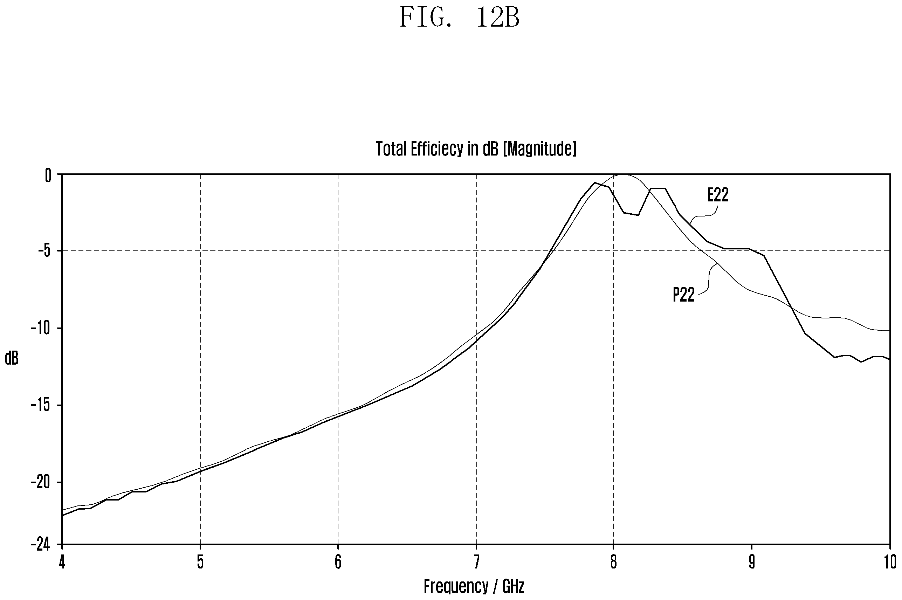

FIG. 12B is a view showing the radiation efficiency of a patch antenna surrounded by a heat dissipation member of an electronic device according to an embodiment of the disclosure, and the radiation efficiency of the patch antenna according to a comparative embodiment.

For example, as illustrated in FIG. 11, the patch antenna 1010 disposed on the dielectric 1001 of the electronic device 300 according to an embodiment of the disclosure may be surrounded by the heat dissipation member 1020.

For example, an electronic device according to a comparative embodiment may include only the patch antenna 1010 disposed on the dielectric 1001, and may include the heat dissipation member 1020 according to an embodiment of the disclosure, which is not disposed to surround the patch antenna 1010.

Referring to FIG. 12B, it can be identified that the radiation efficiency E22 of the patch antenna 1010 according to an embodiment of the disclosure, which uses the heat dissipation member 1020 resonating through coupling with the patch antenna 1010 as an antenna radiation body, is improved compared to the radiation efficiency P22 of the patch antenna 1010 according to the comparative embodiment, which is not surrounded by the heat dissipation member 1020. For example, it can be identified that the radiation efficiency E22 of the patch antenna 1010 surrounded by the heat dissipation member 1020 according to an embodiment of the disclosure is improved compared to the radiation efficiency P22 of the patch antenna 1010 according to the comparative embodiment, in the frequency bands of about 7.5 GHz to 7.9 GHz and about 8.2 GHz to 9.2 GHz.

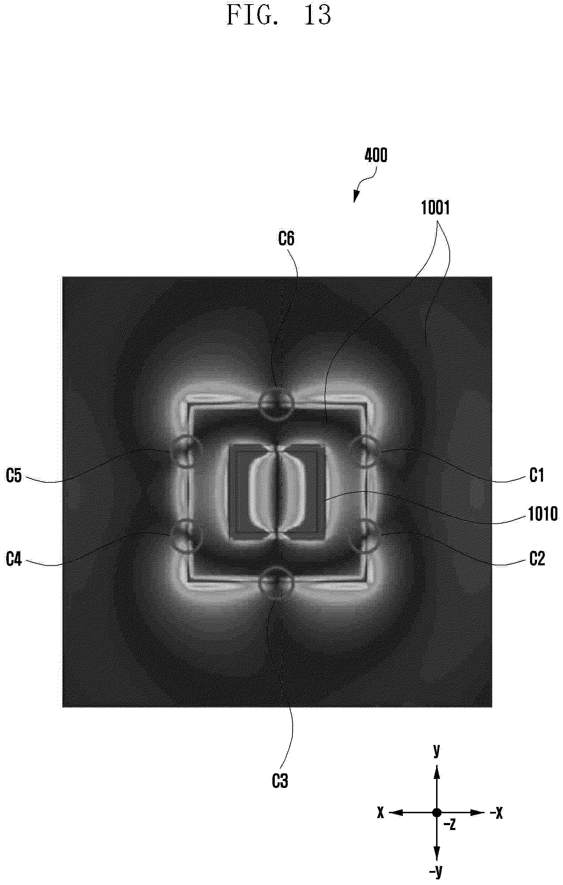

FIG. 13 is a view showing an electric field distribution of a heat dissipation member when a patch antenna operates, in an electronic device according to an embodiment of the disclosure.

Referring to FIG. 13, in case that the patch antenna 1010 disposed in the antenna structure 400 operates, it can be identified that a part of the heat dissipation member 1020, which surrounds the patch antenna 1010, operates as an antenna radiation body.

According to an embodiment, a point, at which the electric field generated from the patch antenna 1010 is zero when the patch antenna 1010 operates, may be identified at a part of the heat dissipation member 1020. For example, the point, at which the electric field of the heat dissipation member 1020 is zero when the patch antenna 1010 operates, may include at least one of a first point c1 and a second point c2 in the -x-axis direction of the heat dissipation member 1020, a third point c3 in the -y-axis direction of the heat dissipation member 1020, a fourth point c4 and a fifth point c5 in the x-axis direction of the heat dissipation member 1020, and a sixth point c6 in the y-axis direction of the heat dissipation member 1020.

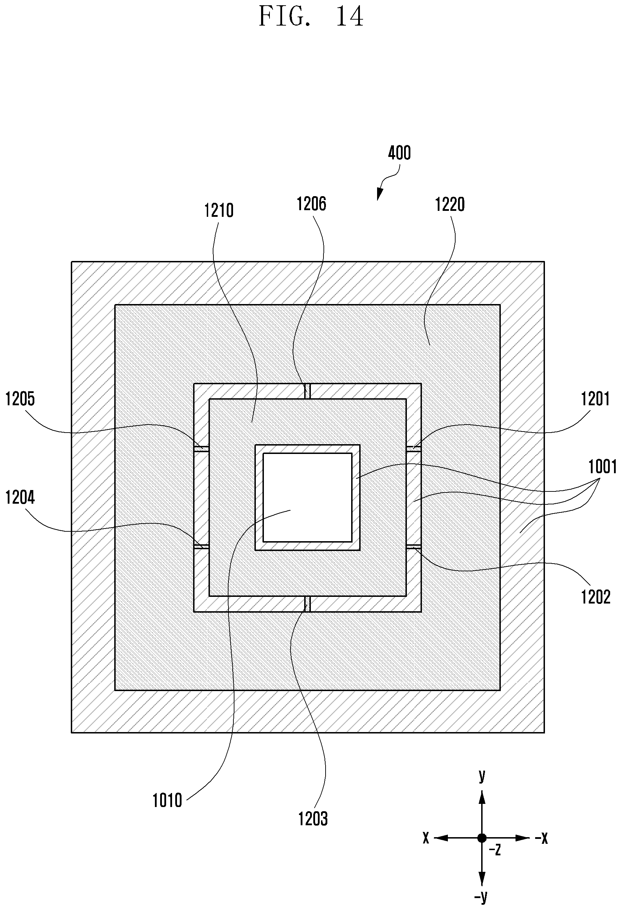

FIG. 14 is a view schematically showing a configuration of an electronic device including a patch antenna structure, a first heat dissipation member, and a second heat dissipation member according to an embodiment of the disclosure.

According to various embodiments, an antenna structure 400 illustrated in FIG. 14 may include the embodiments illustrated in FIG. 11 and FIG. 13.

Referring to FIG. 14, the antenna structure 400 according to an embodiment of the disclosure may include a dielectric 1001 and a patch antenna 1010.

According to an embodiment, the antenna structure 400 may include at least one of a first heat dissipation member 1210 and a second heat dissipation member 1220. As another example, the first heat dissipation member 1210 and/or the second heat dissipation member 1220 may be formed separately and may also be disposed to overlap the dielectric 1001 of the antenna structure 400.

According to an embodiment, the patch antenna 1010 may be disposed on a first surface (e.g., in the -z-axis direction) of the dielectric 1001 or adjacent to the first surface. The patch antenna 1010 may be electrically connected to a wireless communication module (e.g., the wireless communication module 192 in FIG. 1) and thus may receive a feeding signal.

According to an embodiment, the first heat dissipation member 1210 may be disposed on the dielectric 1001 to surround the patch antenna 1010. The first heat dissipation member 1210 may be coupled to the patch antenna 1010 so as to act as an antenna radiation body. For example, the first heat dissipation member 1210 may act as an antenna radiation body by using an electric field coupled to the patch antenna 1010. The first heat dissipation member 1210 may be disposed at a position which enables the patch antenna 1010 to be coupled thereto. The patch antenna 1010 may be coupled to the first heat dissipation member 1210 to improve or enhance the radiation performance thereof.

According to various embodiments, the first heat dissipation member 1210 may be disposed to surround the four surfaces of the patch antenna 1010. For example, the first heat dissipation member 1210 may surround the patch antenna 1010 in the -x-axis direction, the -y-axis direction, the x-axis direction, and the y-axis direction. For example, a part of the dielectric 1001 may be disposed between the first heat dissipation member 1210 and the patch antenna 1010. For example, the first heat dissipation member 1210 and the patch antenna 1010 may be arranged to be separated apart from each other by the part of the dielectric 1001.

According to an embodiment, the second heat dissipation member 1220 may be disposed to surround at least a part of the first heat dissipation member 1210. The second heat dissipation member 1220 may transfer and diffuse heat generated from the antenna structure 400 and the electronic device 300 to another region. For example, a part of the dielectric 1001 may be disposed between the second heat dissipation member 1220 and the first heat dissipation member 1210. For example, the second heat dissipation member 1220 and the first heat dissipation member 1210 may be arranged to be spaced apart from each other by the part of the dielectric 1001.

According to an embodiment, the first heat dissipation member 1210 and the second heat dissipation member 1220 may be connected through at least one of a first connection part 1201, a second connection part 1202, a third connection part 1203, a fourth connection part 1204, a fifth connection part 1205, and a sixth connection part 1206. At least one of the first connection part 1201, the second connection part 1202, the third connection part 1203, the fourth connection part 1204, the fifth connection part 1205, and the sixth connection part 1206 may be disposed at a designated position of the dielectric 1001 disposed between the first heat dissipation member 1210 and the second heat dissipation member 1220. For example, as illustrated in FIG. 13, at least one of the first connection part 1201, the second connection part 1202, the third connection part 1203, the fourth connection part 1204, the fifth connection part 1205, and the sixth connection part 1206 may be formed at a designated point of the first heat dissipation member 1210, at which the electric field generated from the patch antenna 1010 is zero when the patch antenna 1010 operates.

According to an embodiment, for example, the first connection part 1201 and the second connection part 1202 may be arranged at positions substantially the same as the first point c1 and the second point c2, which are in the -x-axis direction of the first heat dissipation member 1210, illustrated in FIG. 13. For example, the third connection part 1203 may be disposed at a position substantially the same as the third point c3, which is in the -y-axis direction of the first heat dissipation member 1210, disclosed in FIG. 13. For example, the fourth connection part 1204 and the fifth connection part 1205 may be arranged at positions substantially the same as the fourth point c4 and the fifth point c5, which are in the x-axis direction of the first heat dissipation member 1210, illustrated in FIG. 13. For example, the sixth connection part 1206 may be disposed at a position substantially the same as the sixth point c6, which is in the y-axis direction of the first heat dissipation member 1210, disclosed in FIG. 13.

According to an embodiment, the second heat dissipation member 1220 may be connected to the first heat dissipation member 1210 through at least one of the first connection part 1201, the second connection part 1202, the third connection part 1203, the fourth connection part 1204, the fifth connection part 1205, and the sixth connection part 1206, and thus may diffuse and transfer heat transferred from the first heat dissipation member 1210 to another region. The second heat dissipation member 1220 may be connected to the first heat dissipation member 1210 through at least one of the first connection part 1201, the second connection part 1202, the third connection part 1203, the fourth connection part 1204, the fifth connection part 1205, and the sixth connection part 1206, so that the heat dissipation area of the electronic device 300 is increased and the heat dissipation efficiency thereof is improved.

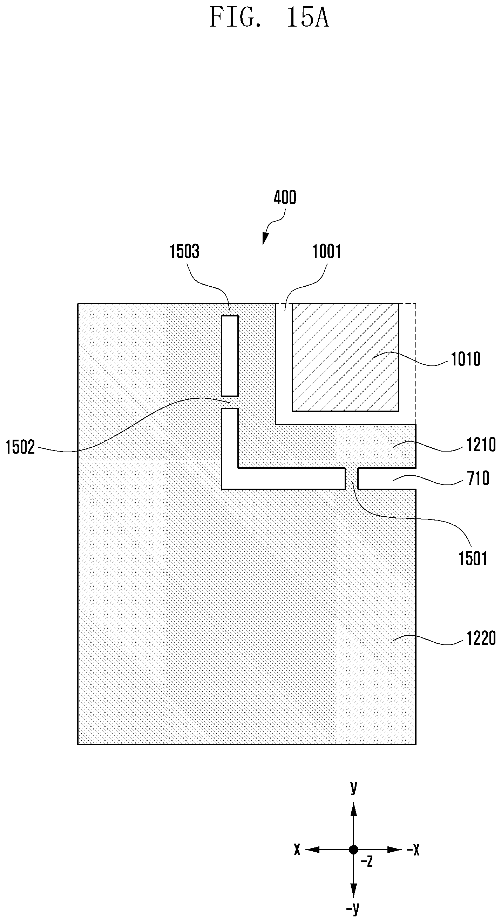

FIG. 15A is a view schematically showing a configuration in which a first heat dissipation member and a second heat dissipation member included in an electronic device are connected through three connection parts according to an embodiment of the disclosure.

According to various embodiments, an antenna structure 400 disclosed below may include the embodiments illustrated in FIG. 11, FIG. 13, and FIG. 14.

Referring to FIG. 15A, the antenna structure 400 according to an embodiment of the disclosure may include a dielectric 1001 and a patch antenna 1010.

According to an embodiment, the antenna structure 400 may also include at least one of a first heat dissipation member 1210 and a second heat dissipation member 1220. As another example, the first heat dissipation member 1210 and the second heat dissipation member 1220 may be formed separately and may also be disposed to overlap the dielectric 1001 of the antenna structure 400.

According to an embodiment, the patch antenna 1010 may be disposed on a first surface (e.g., in the -z-axis direction) of the dielectric 1001 or adjacent to the first surface. The patch antenna 1010 may be electrically connected to a wireless communication module (e.g., the wireless communication module 192 in FIG. 1) and thus may receive a feeding signal.

According to an embodiment, the first heat dissipation member 1210 may be disposed on the dielectric 1001 to surround at least one surface of the patch antenna 1010. The first heat dissipation member 1210 may be coupled to the patch antenna 1010 so as to act as an antenna radiation body. For example, the first heat dissipation member 1210 may act as an antenna radiation body by using an electric field coupled to the patch antenna 1010. The first heat dissipation member 1210 may be disposed at a position which enables the patch antenna 1010 to be coupled thereto. The patch antenna 1010 may be coupled to the first heat dissipation member 1210 to improve or enhance the radiation performance thereof.

According to various embodiments, the first heat dissipation member 1210 may be disposed to surround the patch antenna 1010 in the -y-axis direction and the x-axis direction. For example, a part of the dielectric 1001 may be disposed between the first heat dissipation member 1210 and the patch antenna 1010. For example, the first heat dissipation member 1210 and the patch antenna 1010 may be arranged to be separated apart from each other by the part of the dielectric 1001.

According to an embodiment, the second heat dissipation member 1220 may be disposed to surround at least a part of the first heat dissipation member 1210. The second heat dissipation member 1220 may transfer and diffuse heat generated from the antenna structure 400 and the electronic device 300 to another region. A non-conductive pattern 710 (e.g., a part of the dielectric 1001) may be disposed between the second heat dissipation member 1220 and the first heat dissipation member 1210. The second heat dissipation member 1220 and the first heat dissipation member 1210 may be disposed to be spaced apart from each other by a part of the non-conductive pattern 710.

According to an embodiment, the first heat dissipation member 1210 and the second heat dissipation member 1220 may be connected through at least one of a first connection part 1501, a second connection part 1502, and a third connection part 1503. For example, at least one of the first connection part 1501, the second connection part 1502, and the third connection part 1503 may be disposed at a designated position of the non-conductive pattern 710 disposed between the first heat dissipation member 1210 and the second heat dissipation member 1220. For example, as illustrated in FIG. 13, at least one of the first connection part 1501, the second connection part 1502, and the third connection part 1503 may be formed at a point at which the electric field generated from the patch antenna 1010 is zero when the patch antenna 1010 operates.

According to an embodiment, the first connection part 1501 may be disposed in the - y-axis direction of the first heat dissipation member 1210. The second connection part 1502 and the third connection part 1503 may be arranged in the x-axis direction of the first heat dissipation member 1210.

According to an embodiment, the second heat dissipation member 1220 may be connected to the first heat dissipation member 1210 through at least one of the first connection part 1501, the second connection part 1502, and the third connection part 1503, and may diffuse and transfer heat transferred from the first heat dissipation member 1210 to another region. The second heat dissipation member 1220 may be connected to the first heat dissipation member 1210 through at least one of the first connection part 1501, the second connection part 1502, and the third connection part 1503, so that the heat dissipation area of the electronic device 300 is increased and the heat dissipation efficiency thereof is improved.

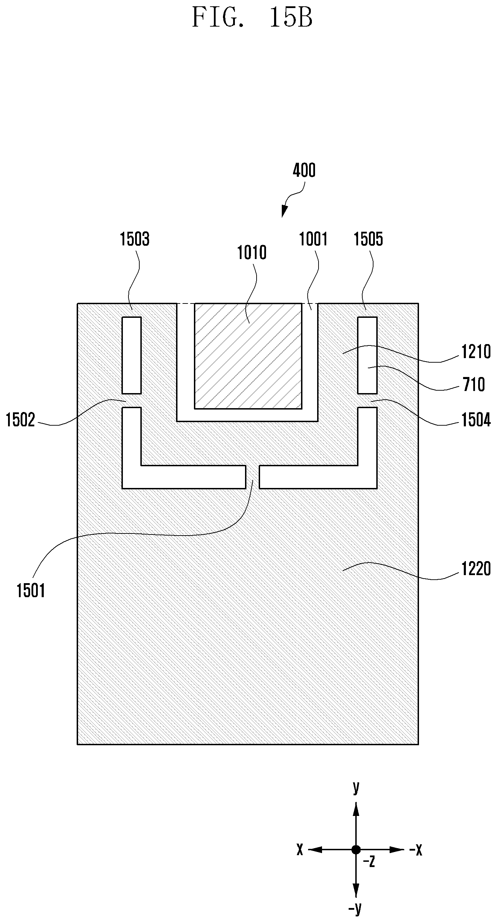

FIG. 15B is a view schematically showing a configuration in which a first heat dissipation member and a second heat dissipation member included in an electronic device are connected through five connection parts according to an embodiment of the disclosure.

Referring to FIG. 15B, the antenna structure 400 according to an embodiment of the disclosure may include a dielectric 1001 and a patch antenna 1010.

According to an embodiment, the antenna structure 400 may also include at least one of a first heat dissipation member 1210 and a second heat dissipation member 1220. As another example, the first heat dissipation member 1210 and the second heat dissipation member 1220 may be formed separately and may also be disposed to overlap the dielectric 1001 of the antenna structure 400.

According to an embodiment, the patch antenna 1010 may be disposed on a first surface (e.g., in the -z-axis direction) of the dielectric 1001 or adjacent to the first surface. The patch antenna 1010 may be electrically connected to a wireless communication module (e.g., the wireless communication module 192 in FIG. 1) and thus may receive a feeding signal.

According to an embodiment, the first heat dissipation member 1210 may be disposed on the dielectric 1001 to surround at least one surface of the patch antenna 1010. The first heat dissipation member 1210 may be coupled to the patch antenna 1010 so as to act as an antenna radiation body. For example, the first heat dissipation member 1210 may act as an antenna radiation body by using an electric field coupled to the patch antenna 1010. The first heat dissipation member 1210 may be disposed at a position which enables the patch antenna 1010 to be coupled thereto. The patch antenna 1010 may be coupled to the first heat dissipation member 1210 to improve or enhance the radiation performance thereof.

According to various embodiments, the first heat dissipation member 1210 may be disposed to surround the patch antenna 1010 in the -x-axis direction, the -y-axis direction, and the x-axis direction. For example, a part of the dielectric 1001 may be disposed between the first heat dissipation member 1210 and the patch antenna 1010. For example, the first heat dissipation member 1210 and the patch antenna 1010 may be arranged to be separated apart from each other by the part of the dielectric 1001.

According to an embodiment, the second heat dissipation member 1220 may be disposed to surround at least a part of the first heat dissipation member 1210. The second heat dissipation member 1220 may transfer and diffuse heat generated from the antenna structure 400 and the electronic device 300 to another region. A non-conductive pattern 710 (e.g., a part of the dielectric 1001) may be disposed between the second heat dissipation member 1220 and the first heat dissipation member 1210. The second heat dissipation member 1220 and the first heat dissipation member 1210 may be disposed to be spaced apart from each other by a part of the non-conductive pattern 710.

According to an embodiment, the first heat dissipation member 1210 and the second heat dissipation member 1220 may be connected through at least one of a first connection part 1501, a second connection part 1502, a third connection part 1503, a fourth connection part 1504, and a fifth connection part 1505. At least one of the first connection part 1501, the second connection part 1502, the third connection part 1503, the fourth connection part 1504, and the fifth connection part 1505 may be disposed at a designated position of the non-conductive pattern 710 disposed between the first heat dissipation member 1210 and the second heat dissipation member 1220. For example, as illustrated in FIG. 13, at least one of the first connection part 1501, the second connection part 1502, the third connection part 1503, the fourth connection part 1504, and the fifth connection part 1505 may be formed at a point at which the electric field generated from the patch antenna 1010 is zero when the patch antenna 1010 operates.

According to an embodiment, the first connection part 1501 may be disposed in the - y-axis direction of the first heat dissipation member 1210. The second connection part 1502 and the third connection part 1503 may be arranged in the x-axis direction of the first heat dissipation member 1210. The fourth connection part 1504 and the fifth connection part 1505 may be arranged in the - x-axis direction of the first heat dissipation member 1210.

According to an embodiment, the second heat dissipation member 1220 may be connected to the first heat dissipation member 1210 through at least one of the first connection part 1501, the second connection part 1502, the third connection part 1503, the fourth connection part 1504, and the fifth connection part 1505, and thus may diffuse and transfer heat transferred from the first heat dissipation member 1210 to another region. The second heat dissipation member 1220 may be connected to the first heat dissipation member 1210 through at least one of the first connection part 1501, the second connection part 1502, the third connection part 1503, the fourth connection part 1504, and the fifth connection part 1505, so that the heat dissipation area of the electronic device 300 is increased and the heat dissipation efficiency thereof is improved.

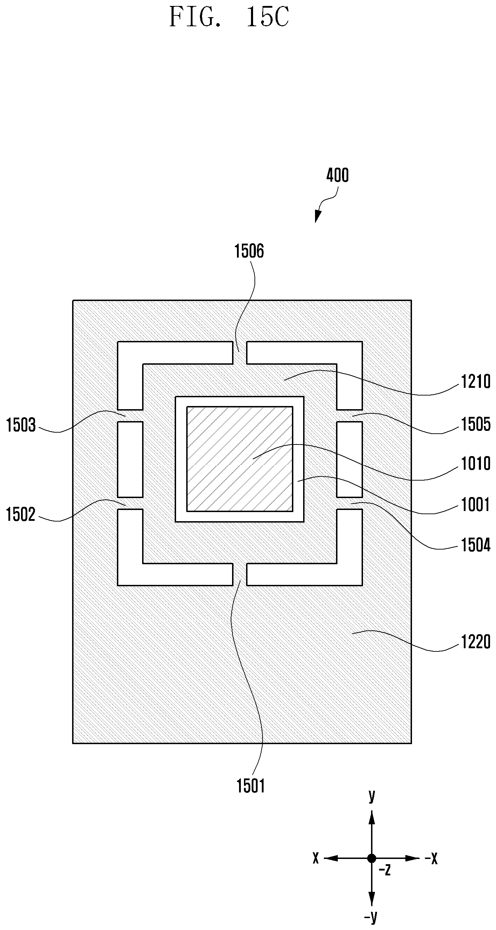

FIG. 15C is a view schematically showing a configuration in which a first heat dissipation member and a second heat dissipation member included in an electronic device are connected through six connection parts according to an embodiment of the disclosure.

Referring to FIG. 15C, the antenna structure 400 according to an embodiment of the disclosure may include a dielectric 1001 and a patch antenna 1010.

According to an embodiment, the antenna structure 400 may also include at least one of a first heat dissipation member 1210 and a second heat dissipation member 1220. As another example, the first heat dissipation member 1210 and the second heat dissipation member 1220 may be formed separately and may also be disposed to overlap the dielectric 1001 of the antenna structure 400.

According to an embodiment, the patch antenna 1010 may be disposed on a first surface (e.g., in the -z-axis direction) of the dielectric 1001 or adjacent to the first surface. The patch antenna 1010 may be disposed substantially at the center of the dielectric 1001. The patch antenna 1010 may be electrically connected to a wireless communication module (e.g., the wireless communication module 192 in FIG. 1) and thus may receive a feeding signal.

According to an embodiment, the first heat dissipation member 1210 may be disposed on the dielectric 1001 to surround the patch antenna 1010. The first heat dissipation member 1210 may be coupled to the patch antenna 1010 so as to act as an antenna radiation body. For example, the first heat dissipation member 1210 may act as an antenna radiation body by using an electric field coupled to the patch antenna 1010. The first heat dissipation member 1210 may be disposed at a position which enables the patch antenna 1010 to be coupled thereto. The patch antenna 1010 may be coupled to the first heat dissipation member 1210 to improve or enhance the radiation performance thereof.

According to various embodiments, the first heat dissipation member 1210 may be disposed to surround the four surfaces of the patch antenna 1010. For example, the first heat dissipation member 1210 may surround the patch antenna 1010 in the -x-axis direction, the -y-axis direction, the x-axis direction, and the y-axis direction. A part of the dielectric 1001 may be disposed between the first heat dissipation member 1210 and the patch antenna 1010. The first heat dissipation member 1210 and the patch antenna 1010 may be arranged to be separated apart from each other by the part of the dielectric 1001.

According to an embodiment, the second heat dissipation member 1220 may be disposed to surround the first heat dissipation member 1210. The second heat dissipation member 1220 may transfer and diffuse heat generated from the antenna structure 400 and the electronic device 300 to another region. A non-conductive pattern 710 (e.g., a part of the dielectric 1001) may be disposed between the second heat dissipation member 1220 and the first heat dissipation member 1210. The second heat dissipation member 1220 and the first heat dissipation member 1210 may be arranged to be spaced apart from each other by at least a part of the non-conductive pattern 710.

According to an embodiment, the first heat dissipation member 1210 and the second heat dissipation member 1220 may be connected through at least one of a first connection part 1501, a second connection part 1502, a third connection part 1503, a fourth connection part 1504, a fifth connection part 1505, and a sixth connection part 1506. At least one of the first connection part 1501, the second connection part 1502, the third connection part 1503, the fourth connection part 1504, the fifth connection part 1505, and the sixth connection part 1506 may be disposed at a designated position of the non-conductive pattern 710 disposed between the first heat dissipation member 1210 and the second heat dissipation member 1220. For example, as illustrated in FIG. 13, at least one of the first connection part 1501, the second connection part 1502, the third connection part 1503, the fourth connection part 1504, the fifth connection part 1505, and the sixth connection part 1506 may be formed at a point at which the electric field generated from the patch antenna 1010 is zero when the patch antenna 1010 operates.

According to an embodiment, the first connection part 1501 may be disposed in the - y-axis direction of the first heat dissipation member 1210. The second connection part 1502 and the third connection part 1503 may be arranged in the x-axis direction of the first heat dissipation member 1210. The fourth connection part 1504 and the fifth connection part 1505 may be arranged in the - x-axis direction of the first heat dissipation member 1210. The sixth connection part 1506 may be disposed in y-axis direction of the first heat dissipation member 1210.

According to an embodiment, the second heat dissipation member 1220 may be connected to the first heat dissipation member 1210 through at least one of the first connection part 1501, the second connection part 1502, the third connection part 1503, the fourth connection part 1504, the fifth connection part 1505, and the sixth connection part 1506, and thus may diffuse and transfer heat transferred from the first heat dissipation member 1210 to another region. The second heat dissipation member 1220 may be connected to the first heat dissipation member 1210 through at least one of the first connection part 1501, the second connection part 1502, the third connection part 1503, the fourth connection part 1504, the fifth connection part 1505, and the sixth connection part 1506, so that the heat dissipation area of the electronic device 300 is increased and the heat dissipation efficiency thereof is improved.

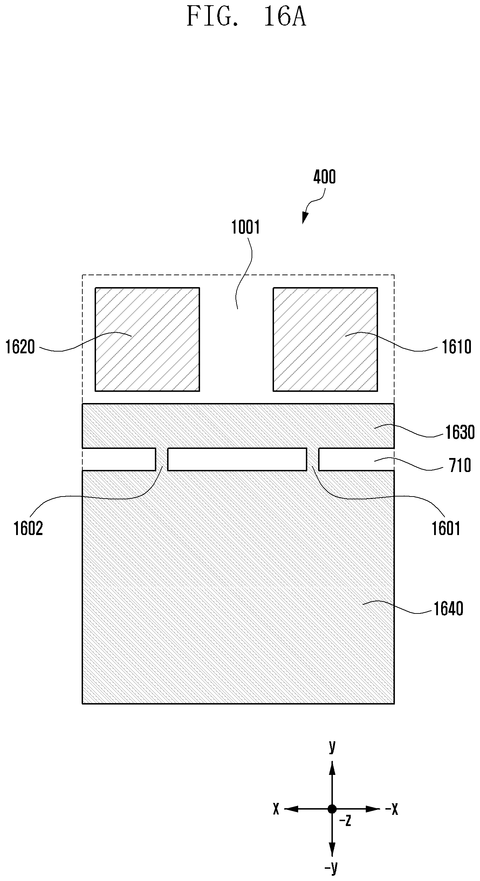

FIG. 16A to FIG. 16E are views schematically showing configurations according to various embodiments of the arrangement structure of a first patch antenna, a second patch antenna, a first heat dissipation member, and a second heat dissipation member included in an electronic device according to an embodiment of the disclosure.

Referring to FIG. 16A to FIG. 16E, an antenna structure 400 according to an embodiment of the disclosure may include a dielectric 1001, a first patch antenna 1610, a second patch antenna 1620, and/or a non-conductive pattern 710.

According to an embodiment, the antenna structure 400 may also include at least one of a first heat dissipation member 1630 and a second heat dissipation member 1640. As another example, the first heat dissipation member 1630 and the second heat dissipation member 1640 may be formed separately and may also be disposed to overlap the dielectric 1001 of the antenna structure 400.

Referring to FIG. 16A, the first patch antenna 1610 and the second patch antenna 1620 may be arranged on a first surface (e.g., in the -z-axis direction) of the dielectric 1001 or adjacent to the first surface. The first patch antenna 1610 and the second patch antenna 1620 may be electrically connected to a wireless communication module (e.g., the wireless communication module 192 in FIG. 1) and may receive a feeding signal.

According to an embodiment, the first heat dissipation member 1630 may be disposed on the dielectric 1001 to surround at least one surface of each of the first patch antenna 1610 and the second patch antenna 1620. The first heat dissipation member 1630 may be coupled to the first patch antenna 1610 and the second patch antenna 1620 so as to operate as an antenna radiation body. For example, the first heat dissipation member 1630 may operate as an antenna radiation body by using an electric field coupled to the first patch antenna 1610 and the second patch antenna 1620. The first heat dissipation member 1630 may be disposed at a position which enables the first patch antenna 1610 and the second patch antenna 1620 to be coupled thereto. The first patch antenna 1610 and the second patch antenna 1620 may be coupled to the first heat dissipation member 1630, so that the radiation performance thereof is improved or enhanced.

According to various embodiments, the first heat dissipation member 1630 may be disposed to surround the first patch antenna 1610 and the second patch antenna 1620 in the -y-axis direction. For example, a part of the dielectric 1001 may be disposed between the first heat dissipation member 1630, the first patch antenna 1610, and the second patch antenna 1620. For example, the first heat dissipation member 1630, the first patch antenna 1610, and the second patch antenna 1620 may be arranged to be spaced apart from each other by the part of the dielectric 1001.

According to an embodiment, the second heat dissipation member 1640 may be disposed to surround at least a part of the first heat dissipation member 1630. The second heat dissipation member 1640 may transfer and diffuse heat generated from the antenna structure 400 and the electronic device 300 to another region. A non-conductive pattern 710 (e.g., a part of the dielectric 1001) may be disposed between the second heat dissipation member 1640 and the first heat dissipation member 1630. The second heat dissipation member 1640 and the first heat dissipation member 1630 may be disposed to be spaced apart from each other by a part of the non-conductive pattern 710.

According to an embodiment, the first heat dissipation member 1630 and the second heat dissipation member 1640 may be connected through at least one of a first connection part 1601 and a second connection part 1602. At least one of the first connection part 1601 and the second connection part 1602 may be disposed at a designated position of the non-conductive pattern 710 disposed between the first heat dissipation member 1630 and the second heat dissipation member 1640. For example, at least one of the first connection part 1601 and the second connection part 1602 may be formed at a point at which the electric field generated from the first patch antenna 1610 and the second patch antenna 1620 is zero when the first patch antenna 1610 and the second patch antenna 1620 operate.

According to an embodiment, the first connection part 1601 and the second connection part 1602 may be arranged in the -y-axis direction of the first heat dissipation member 1630. For example, the first connection part 1601 may be disposed at a position adjacent to one surface (e.g., the surface in the -y-axis direction) of the first patch antenna 1610. For example, the second connection part 1602 may be disposed at a position adjacent to one surface (e.g., the surface in the -y-axis direction) of the second patch antenna 1620.

According to an embodiment, the second heat dissipation member 1640 may be connected to the first heat dissipation member 1630 through at least one of the first connection part 1601 and the second connection part 1602, and may diffuse and transfer heat transferred from the first heat dissipation member 1630 to another region. The second heat dissipation member 1640 may be connected to the first heat dissipation member 1630 through at least one of the first connection part 1601 and the second connection part 1602, so that the heat dissipation area of the electronic device 300 is increased and the heat dissipation efficiency thereof is improved.

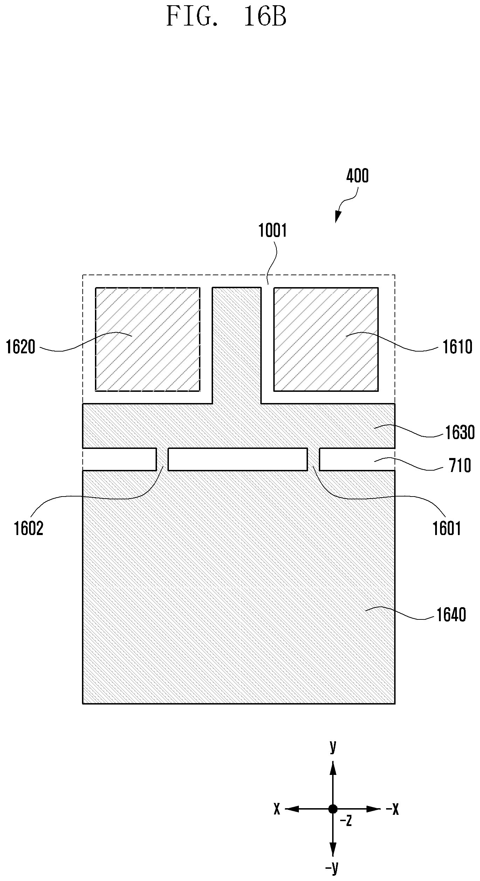

In the description of the antenna structure 400 illustrated below in FIG. 16B to FIG. 16E, the same reference numerals are given to elements substantially identical to those of the antenna structure 400 illustrated in FIG. 16A, and the overlapping descriptions for functions thereof may be omitted. In the description of the antenna structure 400 illustrated below in FIG. 16B to FIG. 16E, only a configuration different from the antenna structure 400 illustrated in FIG. 16A may be described.

Referring to FIG. 16B, the first heat dissipation member 1630 may be disposed to surround at least one surface of each of the first patch antenna 1610 and the second patch antenna 1620. The first heat dissipation member 1630 illustrated in FIG. 16B may further include a portion extending between the first patch antenna 1610 and the second patch antenna 1620, compared to the first heat dissipation member 1630 illustrated in FIG. 16A. For example, the first heat dissipation member 1630 may surround the first patch antenna 1610 in the -y-axis direction and the x-axis direction. The first heat dissipation member 1630 may surround the second patch antenna 1620 in the -y-axis direction and the -x-axis direction.

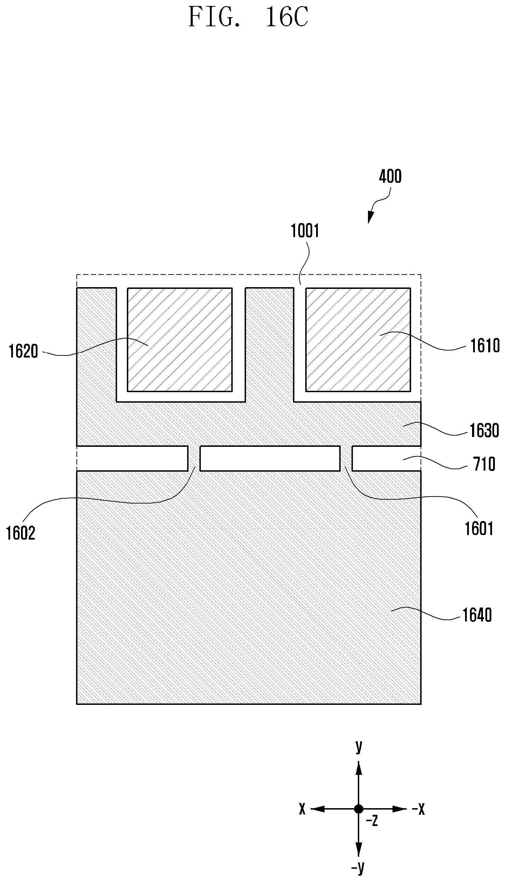

Referring to FIG. 16C, the first heat dissipation member 1630 may be disposed to surround at least one surface of each of the first patch antenna 1610 and the second patch antenna 1620. The first heat dissipation member 1630 illustrated in FIG. 16C may further include a portion extending between the first patch antenna 1610 and the second patch antenna 1620 and along one surface (e.g., the x-axis direction) of the second patch antenna 1620, compared to the first heat dissipation member 1630 illustrated in FIG. 16A. For example, the first heat dissipation member 1630 may surround the first patch antenna 1610 in the -y-axis direction and the x-axis direction. The first heat dissipation member 1630 may surround the second patch antenna 1620 in -y-axis direction, the x-axis direction, and the -x-axis direction.

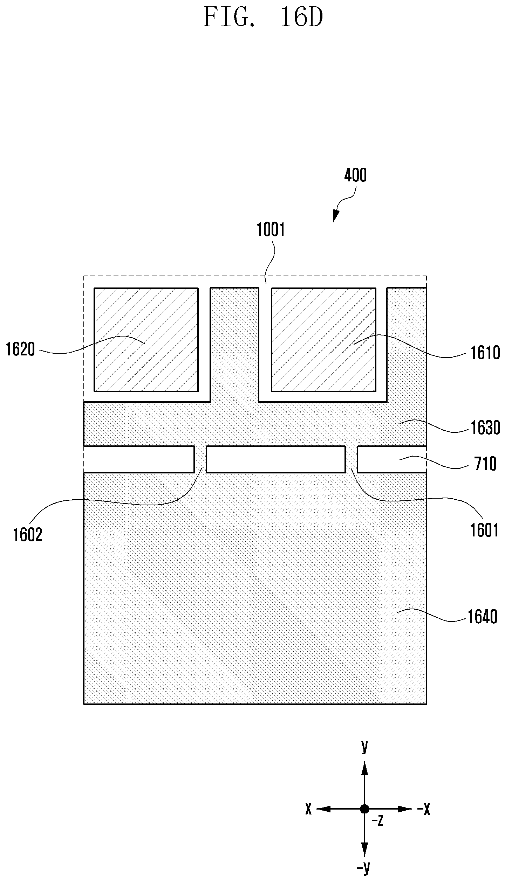

Referring to FIG. 16D, the first heat dissipation member 1630 may be disposed to surround at least one surface of each of the first patch antenna 1610 and the second patch antenna 1620. The first heat dissipation member 1630 illustrated in FIG. 16D may further include a portion extending between the first patch antenna 1610 and the second patch antenna 1620 and along one surface (e.g., the -x-axis direction) of the first patch antenna 1610, compared to the first heat dissipation member 1630 illustrated in FIG. 16A. For example, the first heat dissipation member 1630 may be disposed to surround the first patch antenna 1610 in the -y-axis direction, the x-axis direction, and the -x-axis direction. The first heat dissipation member 1630 may be disposed to surround the second patch antenna 1620 in the - y-axis direction and the -x-axis direction.

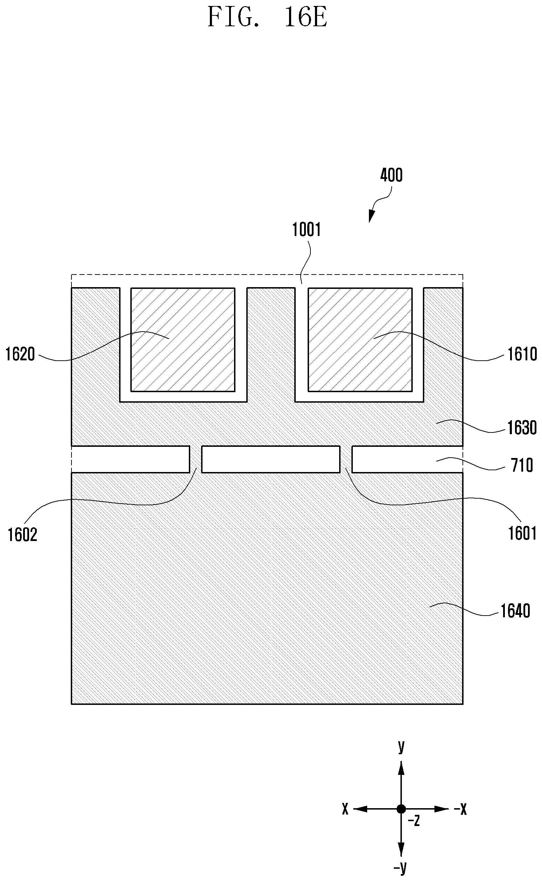

Referring to FIG. 16E, the first heat dissipation member 1630 may be disposed to surround at least one surface of each of the first patch antenna 1610 and the second patch antenna 1620. The first heat dissipation member 1630 illustrated in FIG. 16E may further include a portion extending between the first patch antenna 1610 and the second patch antenna 1620 and along one surface (e.g., the -x-axis direction) of the first patch antenna 1610 and one surface (e.g., the x-axis direction) of the second patch antenna 1620, compared to the first heat dissipation member 1630 illustrated in FIG. 16A. For example, the first heat dissipation member 1630 may be disposed to surround the first patch antenna 1610 in the -y-axis direction, the x-axis direction, and the -x-axis direction. The first heat dissipation member 1630 may be disposed to surround the second patch antenna 1620 in -y-axis direction, the x-axis direction, and the -x-axis direction.

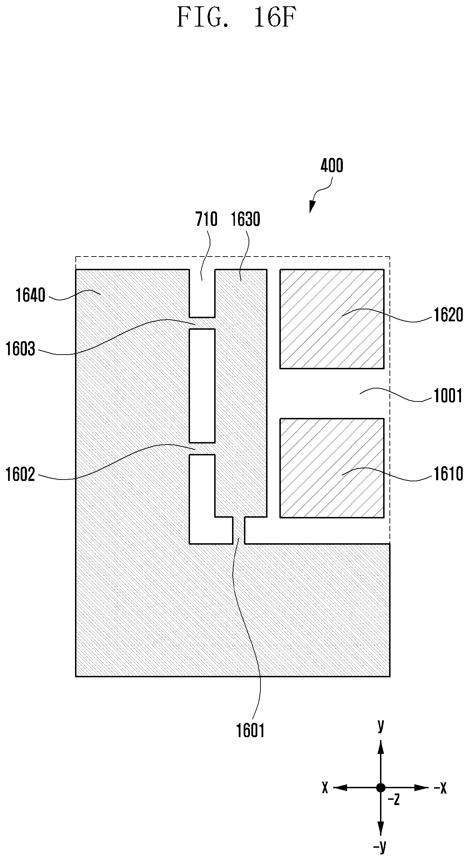

FIG. 16F to FIG. 16H are views schematically showing configurations according to various embodiments of the arrangement structure of a first patch antenna, a second patch antenna, a first heat dissipation member, a second heat dissipation member, and at least one connection part included in an electronic device according to an embodiment of the disclosure.

Referring to FIG. 16F to FIG. 16H, the antenna structure 400 according to an embodiment of the disclosure may include a dielectric 1001, a first patch antenna 1610, a second patch antenna 1620, and/or a non-conductive pattern 710.

According to an embodiment, the antenna structure 400 may also include at least one of a first heat dissipation member 1630 and a second heat dissipation member 1640. As another example, the first heat dissipation member 1630 and the second heat dissipation member 1640 may be formed separately and may also be disposed to overlap the dielectric 1001 of the antenna structure 400.

Referring to FIG. 16F, the first patch antenna 1610 and the second patch antenna 1620 may be arranged on a first surface (e.g., in the -z-axis direction) of the dielectric 1001 or adjacent to the first surface. The first patch antenna 1610 and the second patch antenna 1620 may be electrically connected to a wireless communication module (e.g., the wireless communication module 192 in FIG. 1) and may receive a feeding signal.

According to an embodiment, the first heat dissipation member 1630 may be disposed on the dielectric 1001 to surround at least one surface of each of the first patch antenna 1610 and the second patch antenna 1620. The first heat dissipation member 1630 may be coupled to the first patch antenna 1610 and the second patch antenna 1620 so as to operate as an antenna radiation body. For example, the first heat dissipation member 1630 may operate as an antenna radiation body by using an electric field coupled to the first patch antenna 1610 and the second patch antenna 1620. The first heat dissipation member 1630 may be disposed at a position which enables the first patch antenna 1610 and the second patch antenna 1620 to be coupled thereto. The first patch antenna 1610 and the second patch antenna 1620 may be coupled to the first heat dissipation member 1630, so that the radiation performance thereof is improved or enhanced.

According to various embodiments, the first heat dissipation member 1630 may be disposed to surround the first patch antenna 1610 and the second patch antenna 1620 in the x-axis direction. For example, a part of the dielectric 1001 may be disposed between the first heat dissipation member 1630, the first patch antenna 1610, and the second patch antenna 1620. For example, the first heat dissipation member 1630, the first patch antenna 1610, and the second patch antenna 1620 may be arranged to be spaced apart from each other by the part of the dielectric 1001.

According to an embodiment, the second heat dissipation member 1640 may be disposed to surround at least a part of the first heat dissipation member 1630. For example, the second heat dissipation member 1640 may surround the first heat dissipation member 1630 in x-axis direction and the -y-axis direction. The second heat dissipation member 1640 may transfer and diffuse heat generated from the antenna structure 400 and the electronic device 300 to another region. A non-conductive pattern 710 (e.g., a part of the dielectric 1001) may be disposed between the second heat dissipation member 1640 and the first heat dissipation member 1630. The second heat dissipation member 1640 and the first heat dissipation member 1630 may be disposed to be spaced apart from each other by a part of the non-conductive pattern 710. A portion of the second heat dissipation member 1640 may face the edge in the -y-axis direction of the first patch antenna 1610, but may be spaced apart from the first patch antenna, the position being a position at which the coupling with the patch antennas does not occur.

According to an embodiment, the first heat dissipation member 1630 and the second heat dissipation member 1640 may be connected through at least one of a first connection part 1601, a second connection part 1602, and a third connection part 1603. At least one of the first connection part 1601, the second connection part 1602, and the third connection part 1603 may be disposed at a designated position of the non-conductive pattern 710 disposed between the first heat dissipation member 1630 and the second heat dissipation member 1640. For example, at least one of the first connection part 1601, the second connection part 1602, and the third connection part 1603 may be formed at a point at which the electric field generated from the first patch antenna 1610 and the second patch antenna 1620 is zero when the first patch antenna 1610 and the second patch antenna 1620 operate.

According to an embodiment, the first connection part 1601 may be disposed in the - y-axis direction of the first heat dissipation member 1630. The second connection part 1602 and the third connection part 1603 may be arranged in the x-axis direction of the first heat dissipation member 1630. For example, the second connection part 1602 may be disposed at a position adjacent to one surface (e.g., the surface in the x-axis direction) of the first patch antenna 1610. For example, the third connection part 1603 may be disposed at a position adjacent to one surface (e.g., the surface in the x-axis direction) of the second patch antenna 1620.

According to an embodiment, the second heat dissipation member 1640 may be connected to the first heat dissipation member 1630 through at least one of the first connection part 1601, the second connection part 1602, and the third connection part 1603, and may diffuse and transfer heat transferred from the first heat dissipation member 1630 to another region. The second heat dissipation member 1640 may be connected to the first heat dissipation member 1630 through at least one of the first connection part 1601, the second connection part 1602, and the third connection part 1603, so that the heat dissipation area of the electronic device 300 is increased and the heat dissipation efficiency thereof is improved.

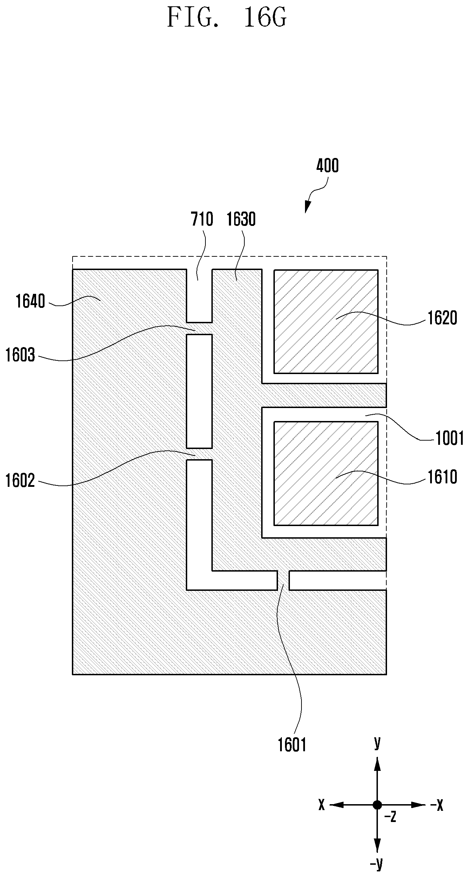

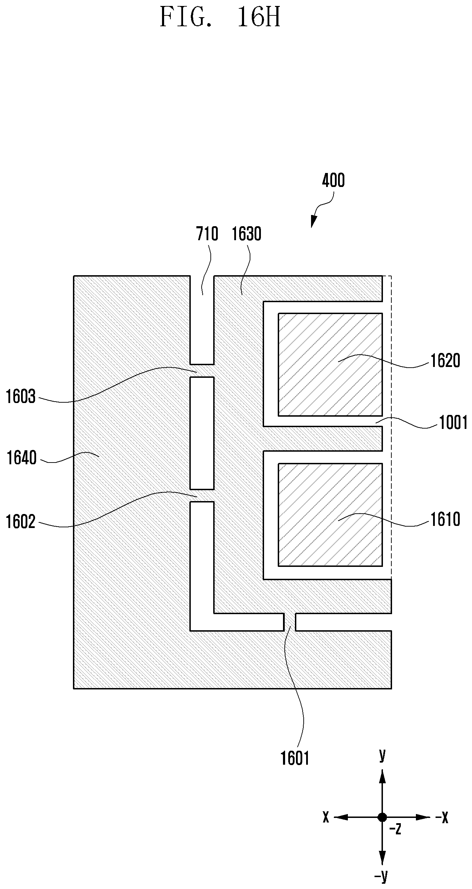

In the description of the antenna structure 400 illustrated below in FIG. 16G and FIG. 16H, the same reference numerals are given to elements substantially identical to those of the antenna structure 400 illustrated in FIG. 16F, and the overlapping descriptions for functions thereof may be omitted. In the description of the antenna structure 400 illustrated below in FIG. 16G and FIG. 16H, only a configuration different from the antenna structure 400 illustrated in FIG. 16F may be described.

Referring to FIG. 16G, the first heat dissipation member 1630 may be disposed to surround at least one surface of each of the first patch antenna 1610 and the second patch antenna 1620. The first heat dissipation member 1630 illustrated in FIG. 16G may further include a portion extending between the first patch antenna 1610 and the second patch antenna 1620 and along one surface (e.g., the -y-axis direction) of the first patch antenna 1610, compared to the first heat dissipation member 1630 illustrated in FIG. 16F. For example, the first heat dissipation member 1630 may be disposed to surround the first patch antenna 1610 in the -y-axis direction, the x-axis direction, and the y-axis direction. The first heat dissipation member 1630 may be disposed to surround the second patch antenna 1620 in the -y-axis direction and the x-axis direction.

Referring to FIG. 16H, the first heat dissipation member 1630 may be disposed to surround at least one surface of each of the first patch antenna 1610 and the second patch antenna 1620. The first heat dissipation member 1630 illustrated in FIG. 16H may further include a portion extending between the first patch antenna 1610 and the second patch antenna 1620 and along one surface (e.g., the -y-axis direction) of the first patch antenna 1610 and one surface (e.g., the y-axis direction) of the second patch antenna 1620, compared to the first heat dissipation member 1630 illustrated in FIG. 16F. For example, the first heat dissipation member 1630 may be disposed to surround the first patch antenna 1610 in the -y-axis direction, the x-axis direction, and the y-axis direction. The first heat dissipation member 1630 may be disposed to surround the second patch antenna 1620 in -y-axis direction, the x-axis direction, and the y-axis direction.

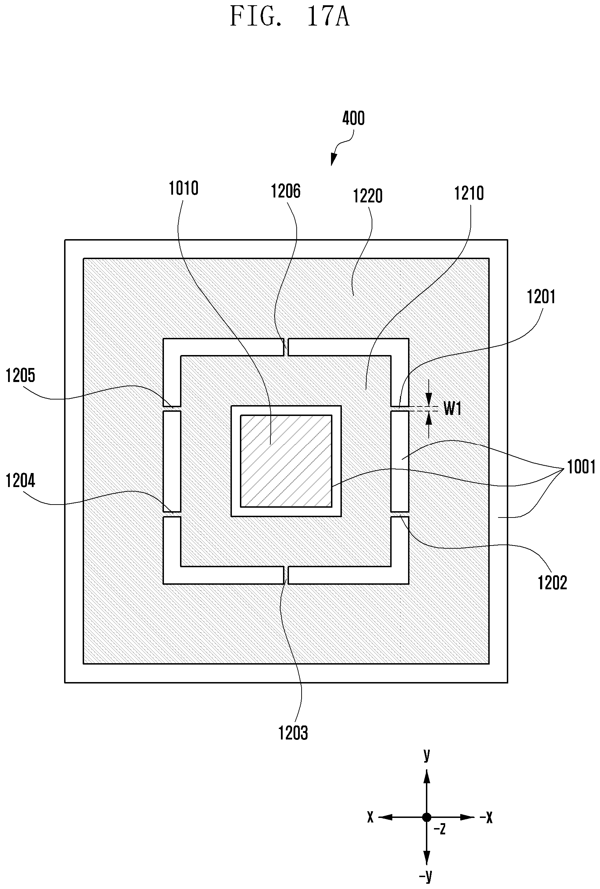

FIG. 17A to FIG. 17D are views schematically showing various widths of a connection part configured to connect a first heat dissipation member and a second heat dissipation member, in an electronic device according to an embodiment of the disclosure.

According to various embodiments, the antenna structure 400 illustrated in FIG. 17A to FIG. 17D may include an embodiment substantially identical to the embodiment illustrated in FIG. 14. In the description of the antenna structure 400 illustrated in FIG. 17A to FIG. 17D, the same reference numerals are given to elements substantially identical to those of the antenna structure 400 illustrated in FIG. 14, and the overlapping descriptions for functions thereof may be omitted. In FIG. 17A to FIG. 17D illustrated below, only the thickness of the first connection part 1201 connecting the first heat dissipation member 1210 and the second heat dissipation member 1220 may be described.

Referring to FIG. 17A, the first heat dissipation member 1210 and the second heat dissipation member 1220 may be connected through at least one of a first connection part 1201, a second connection part 1202, a third connection part 1203, a fourth connection part 1204, a fifth connection part 1205, and a sixth connection part 1206. In an embodiment, the widths of the first connection part 1201, the second connection part 1202, the third connection part 1203, the fourth connection part 1204, the fifth connection part 1205, and the sixth connection part 1206 may be substantially the same. In the embodiment of FIG. 17A, the first connection part 1201 may be formed to have a width W1 of about 0.3 mm to about 0.6 mm.

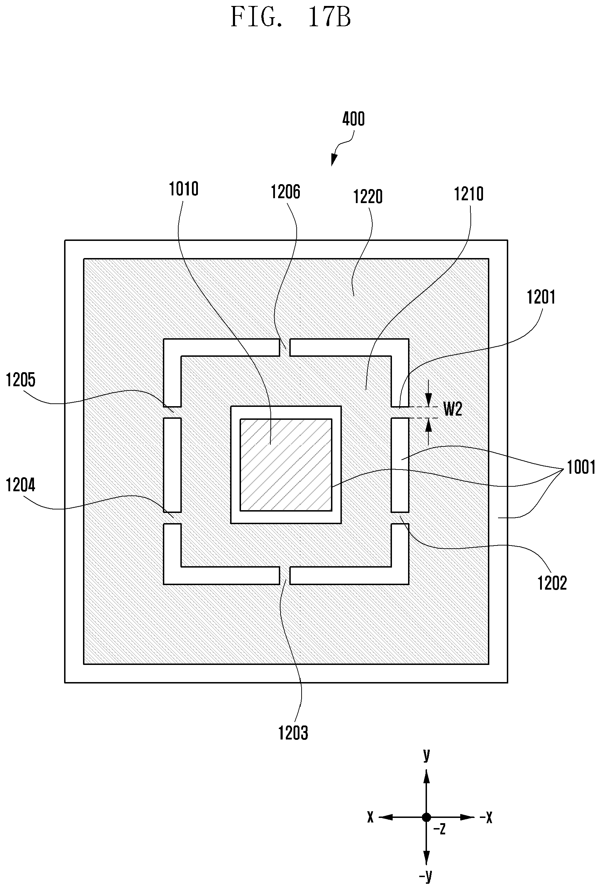

Referring to FIG. 17B, the first connection part 1201, the second connection part 1202, the third connection part 1203, the fourth connection part 1204, the fifth connection part 1205, and the sixth connection part 1206 may have substantially the same width. In the embodiment of FIG. 17B, the first connection part 1201 may be formed to have a width W2 of about λ/16 (e.g., about 1.6 mm) of a target frequency (e.g., about 8 GHz).

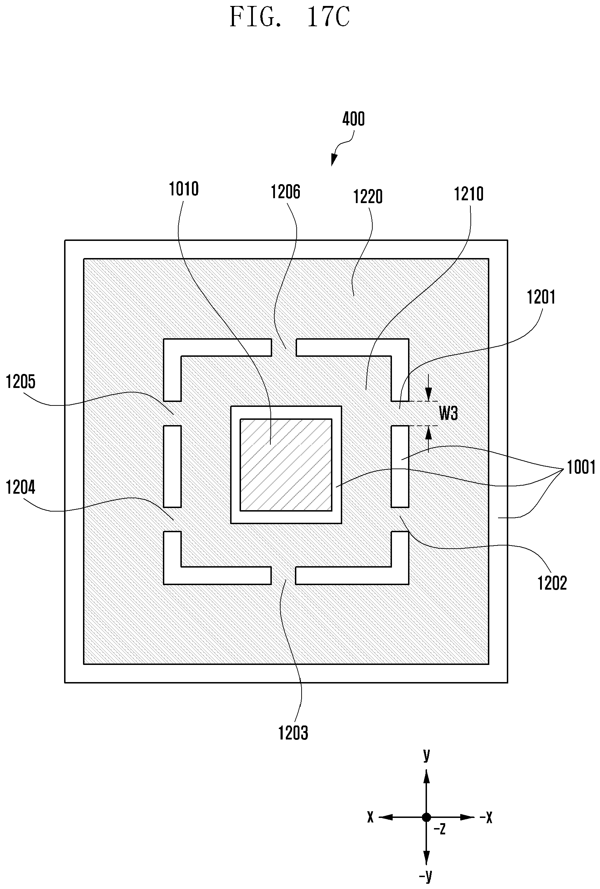

Referring to FIG. 17C, the first connection part 1201, the second connection part 1202, the third connection part 1203, the fourth connection part 1204, the fifth connection part 1205, and the sixth connection part 1206 may have substantially the same width. In the embodiment of FIG. 17C, the first connection part 1201 may be formed to have a width W3 of about λ/8 (e.g., about 3 mm) of the target frequency (e.g., about 8 GHz).

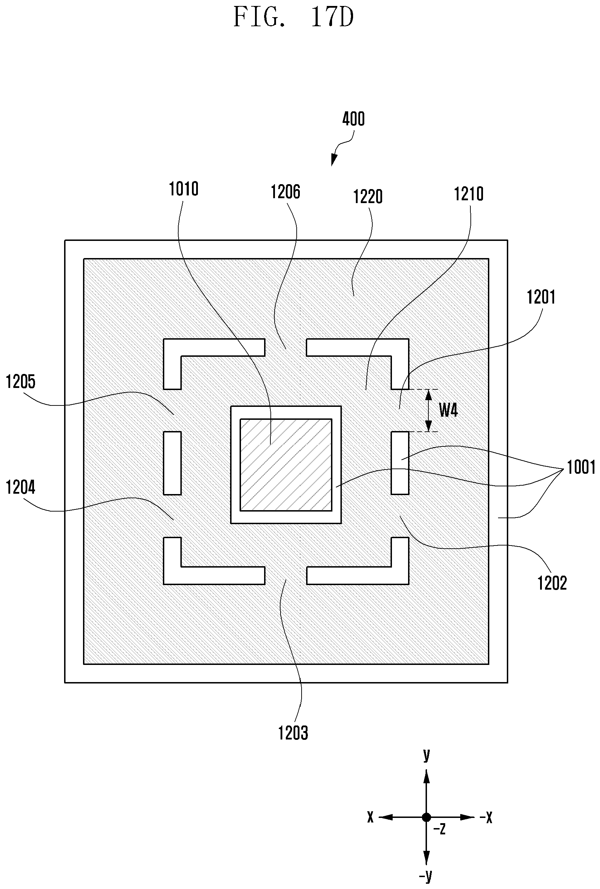

Referring to FIG. 17D, the first connection part 1201, the second connection part 1202, the third connection part 1203, the fourth connection part 1204, the fifth connection part 1205, and the sixth connection part 1206 may have substantially the same width. In the embodiment of FIG. 17D, the first connection part 1201 may be formed to have a width W4 of about λ/4 (e.g., about 6.1 mm) of the target frequency (e.g., about 8 GHz).

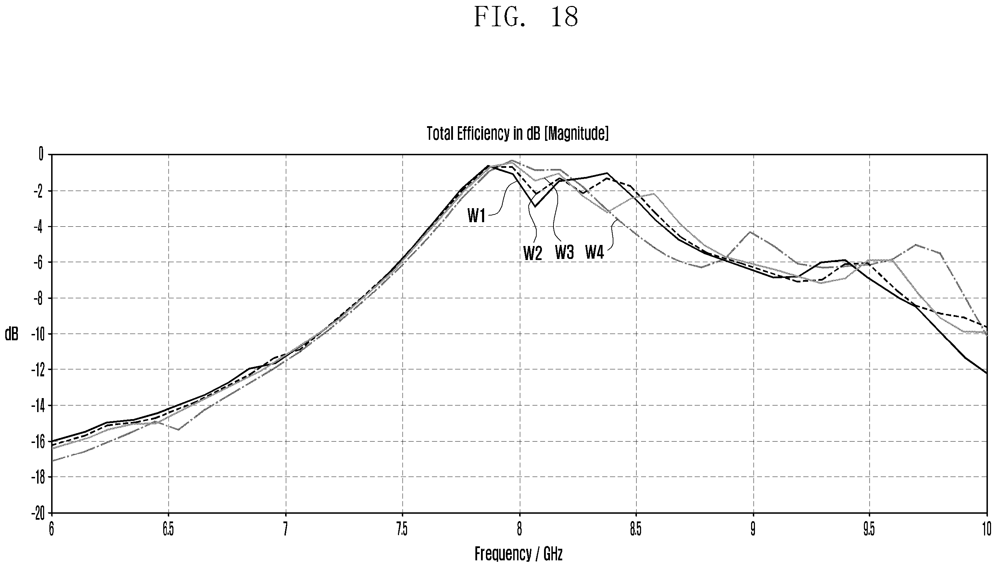

FIG. 18 is a view showing the radiation efficiency of a patch antenna according to the widths of a connection part, in an electronic device according to an embodiment of the disclosure.

According to an embodiment, for example, FIG. 18 may be a view showing comparison of the radiation efficiencies of a patch antenna 1210 according to changes in the widths W1, W2, W3, or W8 of the first connection part 1201 illustrated in FIG. 17A to FIG. 17D.

According to an embodiment, for example, the first connection part 1201 among the first connection part 1201, the second connection part 1202, the third connection part 1203, the fourth connection part 1204, the fifth connection part 1205, and the sixth connection part 1206 may be formed to have a width of about λ/4 (e.g., about 6.1 mm) of or less than the target frequency (e.g., about 8 GHz).

Referring to FIG. 18, although there are changes in the radiation performance thereof at the target frequency (e.g., about 8 GHz) of the patch antenna 1010 according to the widths (e.g., W1, W2, W3, and W4 in FIG. 17A to FIG. 17D) of the first connection part 1201, for example, in case that the first connection part 1201 is formed to have a width smaller than the width W4 of about λ/4 (e.g., about 6.1 mm), it can be identified that the radiation performance of the patch antenna 1010 is maintained.

Referring to FIG. 18, in case that the first connection part 1201 is formed to have the width W1 of about 0.3 mm to 0.6 mm, the width W2 of about λ/16 (e.g., about 1.6 mm), or the width W3 of about λ/8 (e.g., about 3 mm), it can be identified that the radiation performance thereof is maintained substantially similar to each other. In an embodiment, in case that the first connection part 1201 is formed to have the width W4 of about λ/4 (e.g., about 6.1 mm) or more, the radiation performance thereof may be deteriorated.

An electronic device 101, 200, or 300 according to an embodiment of the disclosure may include a housing 210 including a first surface 210A, a second surface 210B, and a side surface 210C surrounding a space between the first surface 210A and the second surface 210B, a printed circuit board 340 which is disposed inside the housing 210 and includes a wireless communication module 192, and an antenna structure 400 electrically connected to the printed circuit board 340 and disposed in one direction of the printed circuit board 340. According to an embodiment, the antenna structure 400 may include a dielectric 401, a first patch antenna 410, a second patch antenna 420, and a third patch antenna 430 arranged on a first surface of the dielectric 401 or adjacent to the first surface and electrically connected to the wireless communication module 192, a ground layer 405 disposed on a second surface of the dielectric 401 or between the second surface and the first patch antenna 410, the second patch antenna 420, and the third patch antenna 430, and a first heat dissipation member 440 which surrounds at least parts of the first patch antenna 410, the second patch antenna 420, and the third patch antenna 430, and is disposed to be couplable to at least one of the first patch antenna 410, the second patch antenna 420, and the third patch antenna 430.

According to an embodiment, at least one of the first patch antenna 410, the second patch antenna 420, and the third patch antenna 430 may be configured to perform a higher-order mode resonance through coupling with the first heat dissipation member 440.

According to an embodiment, the first heat dissipation member 440 may be coupled to at least one of the first patch antenna 410, the second patch antenna 420, and the third patch antenna 430, and be configured to operate as an antenna radiation body.

According to an embodiment, the electronic device may further include a second heat dissipation member 750 surrounding at least a part of the first heat dissipation member 440.

According to an embodiment, a non-conductive pattern 710 may be formed between the first heat dissipation member 440 and the second heat dissipation member 750.

According to an embodiment, the electronic device may further include a support member 360 and an antenna 370, and the second heat dissipation member 750 may be disposed between the support member 360 and the antenna 370.

According to an embodiment, the second heat dissipation member 750 may be disposed in the antenna structure 400.

According to an embodiment, the first heat dissipation member 440 and the second heat dissipation member 750 may be connected through at least one of a first connection part 711 and a second connection part 712.

According to an embodiment, at least one of the first connection part 711 and the second connection part 712 may be disposed at a designated position of the non-conductive pattern 710.

According to an embodiment, at least one of the first connection part 711 and the second connection part 712 may be formed in the non-conductive pattern 710 at a point at which an electric field generated from at least one of the first patch antenna 410, the second patch antenna 420, and the third patch antenna 430 is zero.

According to an embodiment, an edge, which faces at least one of the first patch antenna 410, the second patch antenna 420, and the third patch antenna 430, of the first heat dissipation member 440 may be formed in at least one shape of a concave-convex structure 901, a zigzag shape, a wave shape, and a sawtooth shape.

According to an embodiment, the first patch antenna 410 and the second patch antenna 420 may be arranged to transmit and/or receive a first polarization signal, and the first patch antenna 410 and the third patch antenna 430 may be arranged to transmit and/or receive a second polarization signal.

According to an embodiment, at least one of the first patch antenna 410, the second patch antenna 420, and the third patch antenna 430 may be disposed at a position at which the first heat dissipation member 440 is not coupled.

According to an embodiment, the first heat dissipation member 440 or the second heat dissipation member 750 may include one of a graphite sheet, a copper (CU) sheet, and an aluminum (AL) sheet.

Although the disclosure has been described above according to various embodiments of the disclosure, it is obvious that changes and modifications derived by a person skilled in the technical field to which the disclosure belongs within the scope that does not deviate from the technical idea of the disclosure are also included in the disclosure.

## Claims

1. An electronic device (101, 200, 300) comprising:
a housing (210) comprising a first surface (210A), a second surface (210B), and a side surface (210C) surrounding a space between the first surface (210A) and the second surface (210B);
a printed circuit board (340) which is disposed inside the housing (210) and comprises a wireless communication module (192); and
an antenna structure (400) electrically connected to the printed circuit board (340) and disposed in one direction of the printed circuit board (340),
wherein the antenna structure (400) comprises:
a dielectric (401);
a first patch antenna (410), a second patch antenna (420), and a third patch antenna (430) arranged on a first surface of the dielectric (401) or adjacent to the first surface and electrically connected to the wireless communication module (192);
a ground layer (405) disposed on a second surface of the dielectric (401) or between the second surface and the first patch antenna (410), the second patch antenna (420), and the third patch antenna (430); and
a first heat dissipation member (440) which surrounds at least parts of the first patch antenna (410), the second patch antenna (420), and the third patch antenna (430), and is disposed to be couplable to at least one of the first patch antenna (410), the second patch antenna (420), and the third patch antenna (430).

2. The electronic device of claim 1, wherein at least one of the first patch antenna (410), the second patch antenna (420), and the third patch antenna (430) is configured to perform a higher-order mode resonance through coupling with the first heat dissipation member (440).

3. The electronic device of claim 1 or 2, wherein the first heat dissipation member (440) is coupled to at least one of the first patch antenna (410), the second patch antenna (420), and the third patch antenna (430), and is configured to operate as an antenna radiation body.

4. The electronic device of claim 1 or 2, further comprising a second heat dissipation member (750) surrounding at least a part of the first heat dissipation member (440).

5. The electronic device of claim 4, wherein a non-conductive pattern (710) is formed between the first heat dissipation member (440) and the second heat dissipation member (750).

6. The electronic device of claim 4, further comprising a support member (360) and an antenna (370),
wherein the second heat dissipation member (750) is disposed between the support member (360) and the antenna (370).

7. The electronic device of claim 4, wherein the second heat dissipation member (750) is disposed in the antenna structure (400).

8. The electronic device of claim 5, wherein the first heat dissipation member (440) and the second heat dissipation member (750) are connected through at least one of a first connection part (711) and a second connection part (712).

9. The electronic device of claim 8, wherein at least one of the first connection part (711) and the second connection part (712) is disposed at a designated position of the non-conductive pattern (710).

10. The electronic device of claim 9, wherein at least one of the first connection part (711) and the second connection part (712) is formed in the non-conductive pattern (710) at a point at which an electric field generated from at least one of the first patch antenna (410), the second patch antenna (420), and the third patch antenna (430) is zero.

11. The electronic device of claim 1 or 2, wherein an edge, which faces at least one of the first patch antenna (410), the second patch antenna (420), and the third patch antenna (430), of the first heat dissipation member (440) is formed in at least one shape of a concave-convex structure (901), a zigzag shape, a wave shape, and a sawtooth shape.

12. The electronic device of claim 1 or 2, wherein the first patch antenna (410) and the second patch antenna (420) are arranged to transmit and/or receive a first polarization signal, and
wherein the first patch antenna (410) and the third patch antenna (430) are arranged to transmit and/or receive a second polarization signal.

13. The electronic device of claim 1 or 2, wherein at least one of the first patch antenna (410), the second patch antenna (420), and the third patch antenna (430) is disposed at a position at which the first heat dissipation member (440) is not coupled.

14. The electronic device of claim 4, wherein the first heat dissipation member (440) or the second heat dissipation member (750) comprises one of a graphite sheet, a copper (CU) sheet, and an aluminum (AL) sheet.

15. An antenna structure (400) comprising:
a dielectric (401);
a first patch antenna (410), a second patch antenna (420), and a third patch antenna (430) arranged on a first surface of the dielectric (401) and electrically connected to a wireless communication module (192);
a ground layer (405) disposed on a second surface of the dielectric (401); and
a first heat dissipation member (440) which surrounds at least parts of the first patch antenna (410), the second patch antenna (420), and the third patch antenna (430), and is disposed to be couplable to at least one of the first patch antenna (410), the second patch antenna (420), and the third patch antenna (430).
